(19) Europäisches Patentamt
European Patent Office
Office européen des brevets

(11) **EP 3 904 988 A1**

(12) **EUROPEAN PATENT APPLICATION**

(43) Date of publication:
03.11.2021 Bulletin 2021/44

(51) Int Cl.:
*G05B 23/02* (2006.01)

(21) Application number: 21170408.5

(22) Date of filing: 26.04.2021

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 01.05.2020 US 202016864739
30.09.2020 US 202017038770

(71) Applicant: **Rockwell Automation Technologies, Inc.**
**Mayfield Heights, OH 44124-6188 (US)**

(72) Inventors:
• **MIKLOSOVIC, Robert J.**
**Mayfield Heights (US)**
• **HE, Meiling**
**Mayfield Heights (US)**

(74) Representative: **Grünecker Patent- und
Rechtsanwälte
PartG mbB
Leopoldstraße 4
80802 München (DE)**

(54) **INDUCTION MOTOR CONDITION MONITORING USING MACHINE LEARNING**

(57)     Various embodiments of the present technology generally relate to condition monitoring in industrial environments. More specifically, some embodiments relate to an embedded analytic engine for motor drives that monitors induction motor conditions for potential failures including rotor faults and stator faults. In an embodiment, a condition monitoring module is configured to obtain runtime signal data from a controller within a drive, derive runtime metrics from the runtime signal data based on an induction motor fault condition, provide the runtime metrics as input to a machine learning model constructed to identify a status of the induction motor based on the runtime metrics and output the status, and monitor the induction motor fault condition based on the status of the induction motor output by the machine learning model.

FIGURE 1

## Description

## CROSS-REFERENCE TO RELATED APPLICATIONS

The present application is a continuation-in-part and claims priority to U.S. Application No. 16/864,739 filed May 1, 2020 titled "Industrial Motor Drives with Integrated Condition Monitoring" which is incorporated herein by reference in its entirety for all purposes.

## BACKGROUND

Industrial drives provide power to motors that control mechanical motion within industrial machines in automation environments such as factories, mills, and the like. A controller in a motor drive controls the power provided by circuitry in the drive to a given motor based on process signals supplied by upstream control elements (e.g. push buttons or programmable logic controllers). The mechanics connected to each motor have differed amounts of compliance, backlash, friction gravity, torque disturbances, and changing inertia. As a result, the condition of individual mechanical components, machine-to-machine variations, manufacturing tolerances, and wear over time make every machine degrade at a unique rate.

Condition monitoring is a process of monitoring the condition of the motor and/or its connected mechanical load involved in an industrial process such that the motor drive itself or the upstream control elements can react to potentially damaging faults. The goal of condition monitoring is to predict failures before they happen in order to prevent hazardous operating conditions and unscheduled downtime. Condition monitoring solutions typically monitor machine parameters such as vibration, temperature, and speeds. Typical fault conditions include but are not limited to bearing failure, stator winding failure, broken rotor bars, misalignment, unbalance, friction, and vibration. The parameters may also include voltage and current measurements taken directly from the wiring that connects a drive to a motor.

A condition monitoring solution evaluates parameters against thresholds to determine whether a fault condition exists and, if so, alerts the drive controller or the upstream control elements. Existing condition monitoring is typically performed external to a motor drive. That is, a condition monitoring module resides external to the cabinetry of a drive and gathers its signal data directly from sensors placed on or proximate to the machine or component being monitored. Such configurations introduce added costs and complexity due to the extra hardware and wiring needed to implement the systems.

It is with respect to this general technical environment that aspects of the present technology disclosed herein have been contemplated. Furthermore, although a general environment has been discussed, it should be understood that the examples described herein should not be limited to the general environment identified in the background.

## OVERVIEW

This Overview is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Various embodiments of the present technology generally relate to condition monitoring in industrial environments. More specifically, some embodiments relate to an embedded analytic engine for motor drives. In an embodiment of the present technology, a method of monitoring a condition of an induction motor in an industrial automation environment comprises obtaining runtime signal data in a drive configured to control power supplied to the induction motor in an industrial operation based at least in part on the runtime signal data associated with the industrial operation and deriving runtime metrics from the runtime signal data based on an induction motor fault condition. The method further comprises providing the runtime metrics as input to a machine learning model that is constructed to identify a status of an induction motor fault based on the runtime metrics and monitoring the induction motor fault condition based on the status of the induction motor.

In an implementation of the method, the induction motor fault condition is a rotor fault and deriving the runtime metrics from the runtime signal data comprises deriving runtime metrics specific to identifying rotor faults. The machine learning model may further be constructed (i.e., built and trained) to identify a number of broken rotor bars based on the runtime metrics. In an alternative implementation, the induction motor fault condition is a stator fault and deriving the runtime metrics from the runtime signal data comprises deriving runtime metrics specific to identifying stator faults. The machine learning model may further be constructed to identify a number of shorted turns based on the runtime metrics. In some implementations, the method further comprises obtaining baseline signal data prior to obtaining the runtime signal data, wherein the baseline signal data represents a healthy condition of the induction motor, storing the historical baseline signal data in the drive, and deriving baseline metrics from the baseline signal data. In addition to runtime metries, the baseline metrics arc also provided as input to a machine learning model that is constructed to identify a status of an induction motor fault based on the runtime metrics. Furthermore, in certain implementations, deriving the baseline and runtime metrics comprises determining full spectrum or band-limited frequency responses of the baseline and runtime signal data, determining peak magnitude differences of the frequency responses, and generating a fault signature comprising a torque reference signal, mechanical speed, electrical frequency, functions of the phase currents such as a normalized negative sequence, and the peak magnitude differences of the frequency responses. Baseline metrics during healthy fault conditions along with runtime metrics during healthy and various levels of degraded fault conditions may be used to construct the machine learning model.

In an alternative embodiment, an industrial drive comprises drive circuitry configured to supply power to an induction motor in an industrial operation, a controller coupled with the drive circuitry and configured to control the power supplied to the induction motor based at least in part on runtime signal data associated with the induction motor, and a condition monitoring module. The condition monitoring module is configured to obtain the runtime signal data from the controller, derive runtime metrics from the runtime signal data based on an induction motor fault condition, provide the runtime metrics as input to a machine learning model constructed to identify a status of the induction motor based on the runtime metrics and output the status, and monitor the induction motor fault condition based on the status of the induction motor output by the machine learning model.

In yet another embodiment, one or more computer-readable storage media have program instructions stored thereon to perform condition monitoring in an industrial automation environment. The program instructions, when read and executed by a processing system, direct the processing system to at least, in a motor drive configured to supply power to an induction motor in an industrial operation based at least in part on runtime signal data, obtain the runtime signal data and, in the motor drive, derive runtime metrics from the runtime signal data based on an induction motor fault condition. The program instructions further direct the processing system to, in the motor drive, provide the runtime metrics as input to a machine learning model constructed to identify a status of the induction motor based on the runtime metrics and output the status and, in the motor drive, monitor the induction motor fault condition based on the status of the induction motor output by the machine learning model.

**BRIEF DESCRIPTION OF THE DRAWINGS**

Many aspects of the disclosure can be better understood with reference to the following drawings. The components in the drawings are not necessarily drawn to scale. Moreover, in the drawings, like reference numerals designate corresponding parts throughout the several views. While several embodiments are described in connection with these drawings, the disclosure is not limited to the embodiments disclosed herein. On the contrary, the intent is to cover all alternatives, modifications, and equivalents.

Figure 1 illustrates an industrial automation environment including an embedded analytic engine in accordance with some embodiments of the present technology;

Figure 2 illustrates an industrial process associated with an embedded analytic engine in accordance with some embodiments of the present technology;

Figure 3 illustrates a high-level system architecture of an embedded analytic engine in accordance with some embodiments of the present technology;

Figure 4 illustrates an exemplary architecture of an embedded analytic engine in accordance with some embodiments of the present technology;

Figure 5 illustrates an exemplary architecture of an embedded analytic engine in accordance with some embodiments of the present technology;

Figure 6 illustrates a series of steps for monitoring a condition of an industrial operation in accordance with some embodiments of the present technology;

Figure 7 illustrates a series of steps for monitoring a condition of an industrial device in accordance with some embodiments of the present technology;

Figure 8 illustrates a series of signals associated with an industrial machine and common faults associated with the machine in accordance with some embodiments of the present technology;

Figure 9 illustrates a series of steps for monitoring for broken rotor bars using machine learning in accordance with some embodiments of the present technology;

Figure 10 is a block diagram illustrating monitoring for broken rotor bars using machine learning in accordance with some embodiments of the present technology;

Figure 11 illustrates a series of steps for monitoring for stator failures using machine learning in accordance with some embodiments of the present technology;

Figure 12 is a block diagram illustrating monitoring for stator failures using machine learning in accordance with some embodiments of the present technology;

Figure 13 illustrates an industrial automation environment comprising a plurality of levels from which conditions may be monitored in accordance with some embodiments of the present technology; and

Figure 14 illustrates a computing device that may be used in accordance with some embodiments of the present technology.

The drawings have not necessarily been drawn to scale. Similarly, some components or operations may not be separated into different blocks or combined into a single block for the purposes of discussion of some of the embodiments of the present technology. Moreover, while the technology is amendable to various modifications and alternative forms, specific embodiments have been shown by way of example in the drawings and are described in detail below. The intention, however, is not to limit the technology to the particular embodiments described. On the contrary, the technology is intended to cover all modifications, equivalents, and alternatives falling within the scope of the technology as defined by the appended claims.

## DETAILED DESCRIPTION

The following description and associated figures teach the best mode of the invention. For the purpose of teaching inventive principles, some conventional aspects of the best mode may be simplified or omitted. The following claims specify the scope of the invention. Note that some aspects of the best mode may not fall within the scope of the invention as specified by the claims. Thus, those skilled in the art will appreciate variations from the best mode that fall within the scope of the invention. Those skilled in the art will appreciate that the features described below can be combined in various ways to form multiple variations of the invention. As a result, the invention is not limited to the specific examples described below, but only by the claims and their equivalents.

Various embodiments of the present technology generally relate to condition monitoring in industrial environments. More specifically, embodiments of the present technology include a condition monitoring method for motor drives that requires only input signals available within a motor drive, including motor current and voltage, a torque reference, electrical frequency, and velocity feedback. A unique combination of measurements is applied to specific input signals based on a specified fault condition to be predictcd. Measurements (i.e., metrics) include filtering, full spectrum and band-limited frequency responses, statistical methods, and standard time-domain measurements, such as signal maximum, minimum, root mean square (RMS), and average are applied. These measurements create a machine signature with high information content with respect to a specific fault condition, which then serves as input to one or more machine learning algorithms in order to build a more accurate and repeatable prediction model.

While the analytic engine of the present disclosure is discussed in reference to rotating machinery and motor drives, the technology may be applied to any industrial device to monitor signals other than those discussed herein. In rotating machinery, condition monitoring may refer to monitoring the health of a drive motor, the health of a mechanical load, or both. Condition monitoring plays an important role in industrial processes, as it enables predicting motor and load failures in rotating machinery. High-speed drive signals are sent to a programmable logic controller (PLC) at much lower data rates than they are captured and, as a result, there is loss of information without a simple means to transfer the high-speed data. Thus, embodiments herein include a drive-embedded analytic engine for induction motor condition monitoring. An industrial process, as used in the present disclosure, may include any system comprising one or more industrial operations.

There is no set standard for condition monitoring. However, two of the most common approaches include vibration monitoring and motor current signature analysis (MCSA). Vibration monitoring involves analyzing signals from multiple vibration sensors that are connected to a machine, while MCSA involves analyzing motor current signals that are available within a drive. Both methods perform a fast Fourier transform (FFT) on signal data at high sample rates, apply statistical methods to peak magnitudes at various frequencies of interest, and create custom logic to trigger actions or set status bits. MCSA is often plagued with repeatability and reliability problems while vibration monitoring requires additional sensors, wiring, hardware, and software. As a result of the extra cost, required expertise, and design time, many machine builders do not bother even though they can save a significant amount of money by predicting failures before they happen.

Existing technology does not provide a simple mechanism by which industrial enterprises, facilities, devices, or the like may monitor the health of rotating machinery without requiring multiple hardware components, sensors, and cabling in addition to complex configurations of several parameters across a plurality of software packages. These factors cause set up of such a system to be expensive and time-consuming. Other disadvantages of existing solutions include that they are only suitable for single-drive applications and not suitable for PLC system-level analytics. Furthermore, existing solutions do not work in stand-alone drive applications that do not have communication to external systems. In the industry, there is an overall lack of integrated solutions and configurability, contributing to a need for a simpler, streamlined solution that enables condition monitoring for rotating machinery without excessive costs.

Two important instruments associated with motor control include the variable frequency drive (VFD) and the PLC. VFDs arc used to supply power to motor driven loads, allowing them to operate within a wide range of speeds (i.e., an infinite number of speeds within the operating range). VFDs can control position, speed, torque, acceleration, direction of rotation, and similar variables associated with a rotating machine. The use of VFDs can greatly increase efficiency in a variety of industrial systems such as pumps, compressors, conveyors, cranes, and fan systems. A PLC is a program-based computer used in motor control systems, typically to synchronize the motion across multiple drives.

Thus, an analytic engine embedded in a motor drive (i.e., a VFD) that uses machine learning to detect faults is disclosed. An analytic engine in accordance with the present disclosure may, in some examples, include an application layer that hides configuration complexity and simplifies a user's experience. The analytic engine is configured to monitor various applications and detect degradation of a motor or its detected mechanical load early on. In the process, the analytic engine extracts application specific information from data at the data source. Results in accordance with the present technology are information rich and data light. The results can be easily sent through a network to an associated PLC or may easily be sent through a gateway to an external computing environment (e.g., a cloud) without loss of information, network congestion, and without requiring high-speed data transfer. Data heavy signals are converted to data light information for network transport and may be used for detection at all levels of an industrial environment as a result.

A drive-embedded analytic engine in accordance with the present disclosure enables industrial enterprises, employers, and other users to monitor a motor and connected load in order to dctcct failures before they occur. Predicting electrical, motor-mechanical, and load-mechanical fault conditions before they happen using machine learning may serve to prevent unscheduled downtime and reduce spare parts inventory, for example. Various high-speed, data heavy drive signals may be selected, measured, and analyzed within the drive without requiring additional hardware and wiring and without loss of information. Analytic measurements and outputs of the engine arc information rich and data light and, as a result, can be sent through a network to a PLC controller or through a gateway to a cloud environment for purposes of display, aggregation, and further analysis without bogging down the network. These advantages allow analytic algorithms in a PLC to predict faults that occur across systems with multiple drives and sensors.

As previously mentioned, condition monitoring as discussed herein may be used to detect failure conditions of rotating machinery. Condition monitoring may be performed within the drive (i.e., the VFD) via frequency analysis of phase currents and other drive signals. Known failures associated with motors and mechanical loads may be related to mechanical components of a machine, vibrations, electrical components, and similar aspects of rotating machinery. Certain failures cannot be detected at the controller or cloud level because they use high speed data and memory. Thus, the present technology enables these failures to be detected by detecting failures from within the drive. The present technology may be used to detect failures related to bearings, rotor bars, shafts, windings, oil whirl and whip, rolling elements, gears, teeth, comparators, connectors, or similar componentry associated with rotating machinery. The present technology may detect problems including but not limited to misalignment, unbalance, instability, resonance, wear, damage, degradation, buildup, cracking, bending, breaking, blade pass, vane pass, backlash, blockages, load, looseness, turbulence, rub, eccentricity, phase problems, phasing problems, current, tuning problems, or cavitation and blockage, in addition to other problems associated that may be with rotating machinery. The present technology may be used for vibration monitoring, monitoring of induction motor faults, or monitoring of pumps, fans, blowers, compressors, conveyors, cranes, and hoists, in addition to other equipment employing a motor drive.

Condition monitoring, in accordance with the present technology, includes four foundational steps: input selection, data acquisition, metrics, and detection. Input selection includes selecting the input signal source, such as signals from vibration, temperature, or acoustic sensors or drive signals like phase current and voltage, torque reference, or velocity feedback that may be used in accordance with fault condition monitoring settings for a given scenario. Data acquisition includes capturing data from the selected signals that is related to the fault condition monitoring settings. Metrics involves the process of applying measurements to the captured data. Metrics include converting the captured data content, including high speed data content, to information content, which may be fast information content in some implementations. Converting data content to information content may include the utilization of frequency domain techniques such as fast Fourier Transform (FFT) algorithms, time domain techniques such as extracting average, minimum, maximum, and root mean square (RMS) information, or other transform techniques to extract pattern recognition, correlation, or variance information. The fourth step, detection, is applied to the extracted information to enable the detection of fault conditions. Fault conditions may be detected using thresholds and technology for identifying when thresholds are exceeded. Thresholds may be applied to extracted run time information or to differences between extracted runtime information and extracted baseline information. Detection may additionally or alternatively include machine learning (ML) techniques to predict and detect failures by categorizing conditions or by similar statistical means.

Specific embodiments of the present technology include induction motor condition monitoring using machine learning. More specifically, induction motor condition monitoring includes detecting stator faults and rotor faults. A unique combination of measurements is applied to specific input signals based on which fault condition is being predicted. These measurements create fault signatures with high information content for a given fault. As a result, the effects from load variation are removed, providing more consistent information when machine learning algorithms are applied for prediction.

Stator winding faults may include phase-to-ground faults, phase-to-phase faults, turn-to-turn faults, and coil-to-coil faults. Rotor faults may include broken rotor bars and end ring breakages. Stator winding failures are the result of a short circuit caused by insulation breakdown between adjacent winding turns and account for about 40% of induction machine faults. The insulation failure can quickly expand to the stator core, leading to stator core-ground insulation failure. This process may take 20 to 60 seconds for small, low-voltage motors. For medium voltage (MV) motors, this process may be much faster, due to the high voltages between adjacent turns. These failures may lead to irreversible damage in the windings and/or stator core.

Rotor faults are caused by mechanical stresses (e.g., vibration) and thermal stresses (e.g., design) and account for about 10% of induction machine failure. Rotor faults can affect motor movement characteristics such as the fluctuation and reduction in speed and torque; they can also result in broken parts of the bar hitting the end winding or stator at a high velocity, causing serious damage to the insulation and winding failure.

In existing solutions for rotor fault detection, the asymmetry of the rotor results in a reluctant backward rotating field at slip frequency to the forward rotating rotor. When the rated load is above 70%, rotor faults can be detected by analyzing frequency response magnitudes of motor current in the twice slip frequency ($sf$) sidebands ($f_{rotor} = f_s \pm 2sf$) around the motor electrical frequency ($f_s$). Analyzing these sideband magnitudes has proven insufficient. For example, if the machine runs under a 70% rated load, the metrics proposed don't work. Even when the 70% rated load is obtained, the faulty information is not 100% reliable because some nonadjacent bar breakages may cover up the commonly used fault indices and lead to misdiagnosis of the machine. In other words, the detection threshold changes as a function of motor loading.

In existing solutions for stator fault detection, the incipient short-circuit related faults can be detected by the specific spectrum in the stator current frequency spectrum. The abnormal harmonics are the functions of a list of variables caused by the magneto motive force (MMF) distribution and the permeance-wave representation of the air gap ($f_{stator} = \left\{ k \pm \frac{m}{p}(1-s) \right\} f_s$, where $m = 1,2,3, ... $ , $k = 1,3,5, ...$, respectively, $p$ = pole pairs, $s$ = rotor slip, $f_s$ = motor electrical frequency, and $f_{stator}$ = short circuit related frequency harmonic). It has also been found that the 5th harmonic of the normalized negative sequence current has a linear correlation with inter-turn faults and is independent of voltage harmonic components and the modulation index suggested on paper.

Key disadvantages of these solutions include that the negative-sequence currents components from the negative sequence currents can also be caused by unbalanced power supply and the intrinsic asymmetry in induction motors. The negative-sequence current due to motor inherit asymmetry is also load and slip dependent, which makes it difficult to set threshold for the fault signatures. Furthermore, the stator fault signature from the currents is very close to frequency components related to other kinds of defects, such as eccentricities. It is important to isolate one from the other for correct detection. The fault signature is also affected by the current harmonics caused by power supply harmonics and load oscillation. Therefore, MCSA is not sufficient for use in identifying stator faults.

A typical machine learning system may include feature extraction, feature selection, and classification. In the present technology, typical feature extraction and selection are replaced by a unique combination of measurements (i.e., metrics) that are taken from specific input signals captured initially (i.e., a baseline version) and most recently (i.e., the runtime version). These measurements create fault signatures with high information content for a given fault. It should be noted that this approach differs from standard feature extraction and selection techniques that use input signals that are all captured at the same time, regardless of whether they are for healthy or unhealthy conditions. A support vector machine (SVM) classifier is applied to measurements that are taken under healthy (i.e., baseline) and unhealthy (i.e., runtime) conditions. This historical data is used to build and train a model that is used for early detection of rotor and stator faults with high accuracy and repeatability.

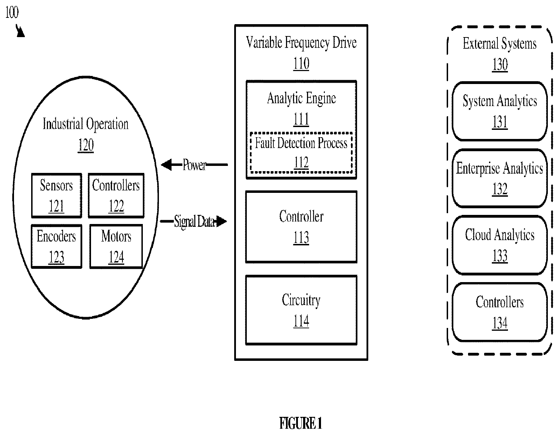

Figure 1 illustrates an example of an industrial environment in which aspects of the present technology may be implemented. Environment 100 includes variable frequency drive 110, industrial operation 120, and external systems 130. Variable frequency drive 110 includes analytic engine 111, controller 113, and circuitry 114. Industrial operation 120 includes sensors 121, PLC automation controllers 122, encoders 123, and motors 124. External systems 130 includes system analytics 131, enterprise analytics 132, cloud analytics 133, and PLC automation controllers 134. Industrial operation 120 may represent any industrial machine or system powered by variable frequency drive 110. The components of variable frequency drive 110 and industrial operation 120 may differ depending on a given implementation. Systems shown herein may include additional components, fewer components, and different components and may still be in accordance with the technology of the present example. Likewise, sensors 121, PLC automation controllers 122, and encoders 123 may each represent any number of sensors, controllers, and encoders, respectively, associated with industrial operation 120. External systems 130 serves to represent or include any layer of an industrial automation environment external to variable frequency drive 110, wherein external analytics system may collect and analyze data from analytic engine 111 and/or separately from analytic engine 111 and perform system analytics.

Variable frequency drive 110 supplies power to motors 124 of industrial operation 120 and receives signal data from industrial operation 120. Analytic engine 111 runs fault detection process 112 to detect faults within industrial operation 120 based on the signal data. Analytic engine 111 is a configurable analytics processor that provides flexibility for condition monitoring and includes an application layer that hides complexity and simplifies the user experience for individual applications and fault detection. Analytic engine may be configured to monitor various applications and detect degradation or other faults of a motor and a connected mechanical load from industrial operation 120.

Although analytic engine 111 may be in communication with any analytics system of external systems 130, analytics engine 111 does not require external systems to perform condition monitoring in accordance with the technology disclosed herein. To perform condition monitoring within the drive, analytic engine 111 may implement fault detection process 112 independently from external systems 130. However, in some examples, external systems 130 may be in communication with analytic engine 111, components of industrial operation 120, or combinations thereof and external systems 130 may perform condition monitoring independently of analytic engine 111 or based on data from analytic engine 111.

In some examples, an enterprise may use analytic engine 111 as one component of a greater condition monitoring and analysis system within the enterprise. A modular topology may utilize analytic engine 111 at the drive level in addition to processes and analyses performed at the system and enterprise level. At the drive level, analytic engine 111 may collect data from devices of industrial operation 120 and other sources in various formats. Analytic engine may use collected data to perform condition monitoring, power and energy monitoring, predictive life analysis, load characterization, or similar analyses. At the system level, system analytics 131 may aggregate and contextualize information to detect system level fault conditions and/or provide insights related to preventative maintenance, energy diagnostics, system modeling, performance optimization, and similar insights. At the enterprise level, enterprise analytics, cloud analytics, or a combination thereof may present information to users on devices and systems including mobile devices and desktop computers to enable remote learning, machine learning, and root cause analysis.

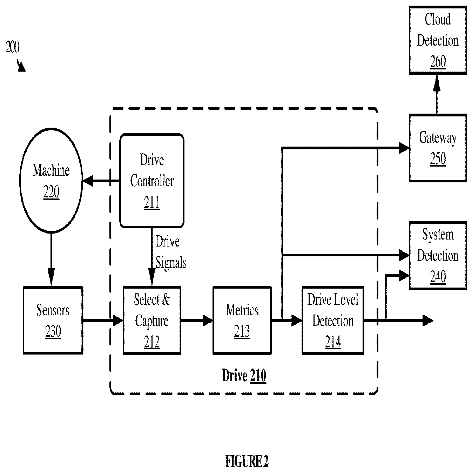

Figure 2 illustrates an example of a condition monitoring environment for fault detection at the drive level. Environment 200 includes drive 210 representative of a variable frequency drive comprising an analytics engine such as variable frequency drive 110. Components of drive 210 serve to represent functionality of a drive comprising an analytics engine for device-level condition monitoring. Drive controller 211 provides an output supplied to machine 220, which may be representative of any motor-driven industrial operation including industrial operation 120. Sensors 230 may include vibration, temperature, acoustic, or other external sensors that collect data related to operation of machine 220 and provide the data to select and capture module 212. Select and capture module 212 collects data from a drive signal or sensors 230, depending on what signal is selected, and provides the captured data to metrics module 213. Select and capture module 212 is used during baseline and runtime captures. Metrics module 213 processes the data to generate metrics data that can be utilized for fault detection. The data collected by select and capture module 212 and the processing performed by metrics module 213 may, in some embodiments, depend on settings specific to one or more fault conditions being monitored. For example, for a given fault condition, settings may change which drive signal is selected to capture in select and capture module 212 as well as the manner in which metrics module 213 processes the data by changing signal paths to implement various filters and algorithms, performing measurements, utilizing specific parameters, or other settings that may affect processing to produce metrics specific to a fault condition. Metrics are calculated independently for baseline and runtime captures and then differences are calculated between them. Metrics may then be output by metrics module 213 and provided to one or more systems and modules for condition monitoring. A fault condition in accordance with the present example may include a fault condition associated with the motor or a fault condition associated with an associated mechanical load.

The output of metrics module 213 is provided to drive level detection module 214 which may then use the metrics produced by metrics module 213 to perform fault detection within drive 210. Drive level detection, in some examples, comprises determining if one or more fault conditions is present based on the settings specific to at least one fault being monitored. Detection methods include thresholding or machine learning. In addition to supplying the metrics to drive level detection module 214, metrics may be provided to additional systems for condition monitoring or other purposes. In the present example, metrics arc provided to system detection module 240 for system-level fault dctcction. Metrics arc also provided to gateway 250 and ultimately to cloud detection module 260 for enterprise-level fault detection. Metrics may be provided to additional systems or locations. Similarly, drive level detection module 214 may provide detection results to one or more external locations including system detection module 240. Drive level detection module 214 may provide results to gateway 250, cloud detection module 260, or any other system in communication with drive level detection module 214.

In an embodiment of the present technology, drive signals specific to detecting broken rotor bars in an induction motor are selected and captured in select and capture module 212 and then fed to metrics module 213. In the present embodiment, metrics module 213 is configured to perform specific metrics on the signals for broken rotor bar dctcction. The metrics may include identifying specific frequency response bands or performing RMS calculations on the drive signals. The metrics are then provided to drive level detection module 214, in which one or more machine learning techniques are applied to detect broker rotor bar fault conditions. In an example, the one or more machine learning techniques include an SVM classifier.

In another embodiment of the present technology, drive signals specific to detecting stator winding failures in an induction motor are selected and captured in select and capture module 212 and then fed to metrics module 213. In the present embodiment, metrics module 213 is configured to perform specific metrics on the signals for stator winding failure detection. The metrics may include identifying specific frequency response bands or performing RMS calculations on the drive signals. The metrics are then provided to drive level detection module 214, in which one or more machine learning techniques are applied to detect stator winding failure conditions. In an example, the one or more machine learning techniques include an SVM classifier.

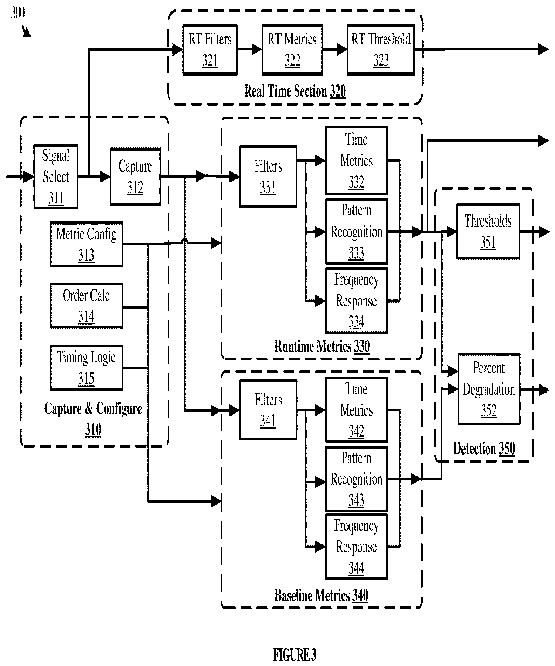

Figure 3 includes a high-level diagram of the architecture of a configurable core processor for performing condition monitoring in a drive in accordance with some embodiments of the present technology. The drive in which the configurable core processors resides is at least one of the drives supplying power to an industrial operation, wherein the industrial operation includes at least a motor and a connected mechanical load. The condition monitoring performed by the processor in the drive may include monitoring for conditions associated with the motor, conditions associated with the connected mechanical load, and variations or combinations thereof. Architecture 300 includes capture and configure section 310, real time section 320, runtime metrics section 330, baseline metrics section 340, and detection section 350. The configurable analytics processor of the present example may be employed within a variable frequency drive and serves to, at least in part, convert data heavy signals to data light information suitable for network transport and detection at all levels of an industrial enterprise. Capture and configure section 310 comprises signal select 311, capture 312, metric configurations 313, order calculations 314, and timing logic 315. Signal select 311 may select input data based on one or more fault conditions to be monitored. Selectable inputs may include motor current and voltage, data from external connected sensors, internal drive signals (including signals generated from local digital twin models), and additional inputs and signals related to function of an industrial operation. Capture 312 may collect the selected data for condition monitoring while metric configurations 313, order calculations 314, and timing logic 315 may provide inputs and settings to metrics sections for producing metrics specific to the one or more fault conditions being monitored. Order calculations 314 allow filters 331, filters 341, frequency response 334, and frequency response 344 to track changing mechanical speed or changing electrical frequency (speed). Frequency responses may rescale the frequency vector as a function of a changing speed, allowing magnitudes and phases to not shift in frequency during variable speed operation of the drive.

Outputs of capture and configure section 310 further include feeding the selected signals directly to real time section 320. Real time section 320 includes real time filters 321, real time metrics 322, and real time threshold 323. Once the appropriate filters, metrics, and thresholds have been applied to process the real time signals, real time output may be provided in addition to other outputs of the processor. The real time channel provides high speed (i.e., fast) fault detection for protection situations.

Metrics are signals that are much smaller and higher in information content than the signals going into capture and configure section 310. The smaller signals are able to be sent through a network without loss of information and/or network congestion and sending the metrics does not require high speed data transfer. Runtime metrics section 330 and baseline metrics section 340 convert data heavy signals to data light metrics that may be used to detect fault conditions within the drive. Fault conditions may include faults associated with the motor of an industrial operation and faults associated with a mechanical load of the industrial operation. The data light metrics further enable data to be communicated to external systems for fault detection or other monitoring purposes. Runtime metrics section 330 produces metrics from recent data according to settings specific to the one or more fault conditions being monitored. Baseline metrics section 340 produces baseline metrics from historical baseline data for purposes of determining percent degradation and similar metries that may address changes in function. Baseline metrics may be collected whenever the machine or industrial operation is running under healthy operating conditions, such as when a new device or component is installed, such that recent metrics can be compared to how the system functioned initially.

Runtime metrics section 330 includes filters 331, time metrics 332, pattern recognition 333, and frequency response 334. Baseline metrics section includes filters 341, time metrics 342, pattern recognition 343, and frequency response 344. The modules included in architecture 300 may represent different numbers of physical components depending on a specific implementation. Each of runtime metrics section 330 and baseline metrics section 340 may independently apply simultaneous measurements to input signals and supply detection section 350 with any combination of simultaneous measurements. Simultaneous measurements and metrics produced may include filtering, time domain metrics, frequency domain metrics, and pattern domain metrics. Time and frequency domain metrics may include metrics such as signal average, signal normalization, signal maximum, signal minimum, RMS, band limited frequency responses, variance and covariance, correlation and cross correlation, in addition to various filters and pattern recognition modules. A pattern recognition technique having a small computational footprint may be applied in some implementations. A pattern recognition technique used in accordance with the present example may be fast and require little processing power. The metrics produced by runtime metrics section 330 and baseline metrics section 340 are configurable such that analytics may be produced for any application including fault detection and condition monitoring. Settings may differ within each section or within modules of each section depending on which fault condition is being monitored.

Metrics are then provided to detection section 350 comprising thresholds 351 and percent degradation 352 in addition to any other specified output locations such as additional condition monitoring modules within the drive or external systems. Differences may then be calculated between baseline metrics and the recent metric calculations. Percent degradation 352 may utilize a detection method that determines the percent of degradation between the baseline metrics and the recent metrics. Percent degradation may be communicated to other modules or systems. Differences are also combined in a configurable, weighted sum difference allowing application-dependent information to be represented by a single number. Thresholds 351 may perform a variety of different condition monitoring functions including determining whether any measurements or metrics exceeded thresholds indicating an unhealthy state. Specific thresholds may be set to show when metrics exceed predetermined values. The outputs of differences and thresholds are averaged over a specified number of detection cycles to mitigate noise and other undesirable instantaneous effects. Condition monitoring information may then be communicated to other modules or systems in some examples. Detection section 350, in some examples, may display measurements, differences, or percent degradation. Differences and percentages may be displayed to give users a real-time or near real-time indication of the amount of mechanical and electrical degradation over time.

In some examples, one or more modules of detection section 350 may apply machine learning techniques to predict faults within the system. Similarly, machine learning methods may be utilized within a detection module at the system level to predict system level faults across connected systems with multiple drives and sensors. In certain implementations, an artificial intelligence computer module is utilized in the PLC rack and applies machine learning technology to predict faults.

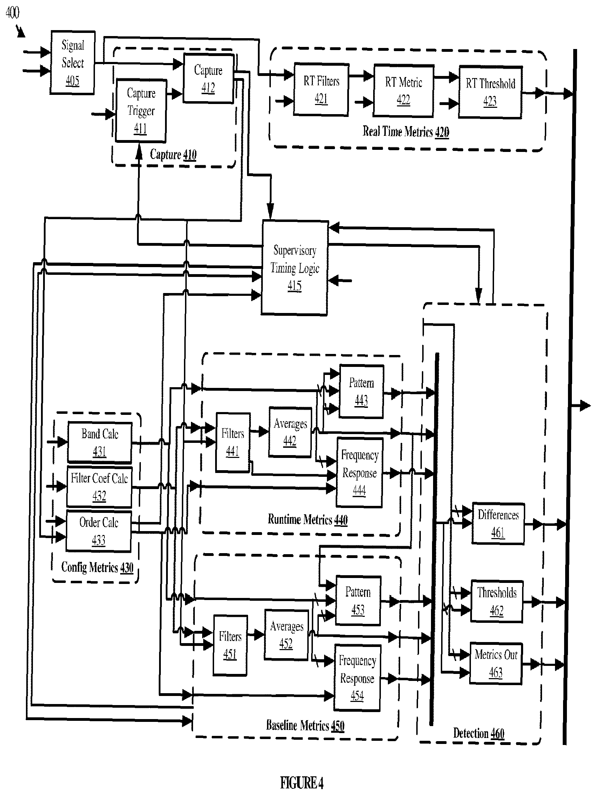

Figure 4 illustrates a detailed diagram illustrating an exemplary design of an embedded analytics engine for motor drives in accordance with some embodiments of the present technology. Each of the components, modules, groupings, and relationships are shown for purposes of illustration and do not intend to limit the actual number or groupings of components used to implement an embedded analytics engine disclosed herein. The embedded analytics engine of the present example may reside in a motor drive that supplies power to an industrial operation, wherein the industrial operation comprises at least a motor and a connected mechanical load. The embedded analytics engine may then be used to monitor fault conditions of the industrial operation, including fault conditions of the motor, the mechanical load, and variations or combinations thereof. Analytics engine 400 comprises many similar components to architecture 300 from Figure 3, however it provides more detail regarding the interconnection of supervisory timing logic 415. In some examples, some components of architecture 300 and analytics engine 400 may be the same. Analytics engine 400 includes capture 410, supervisory timing logic 415, real time metrics 420, configure metrics 430, runtime metrics 440, baseline metrics 450, and detection 460.

Similar to the previous example, signal select 405 selects runtime signals to be used for condition monitoring by the analytics engine. Selected signals may then be captured by capture 412 and additional signals may be captured by capture trigger 411 and provided to capture 412. Capture 412 provides captured data to supervisory timing logic 415, real time filters 421, and order calculations 433. Real time filters 421 may also receive selected signals directly from signal select 405 for high speed fault detection for protection situations. Real time metrics 420 includes real time filters 421, real time metrics 422, and real time threshold 423. Once the appropriate filters, metrics, and thresholds have been applied to process the real time signals, real time output may be provided in addition to other outputs of the processor. The real time channel provides high speed (i.e., fast) fault detection for protection situations.

Supervisory timing logic 415 may provide timing logic to various modules throughout analytics engine 400 including but not limited to capture trigger 411, baseline metrics 450, detection 460, and additional locations in some embodiments. Supervisory timing logic 415 also receives timing information from capture 412, baseline metrics 450, order calculations 433, detection 460, and additional timing configuration locations in some embodiments. The main task of supervisory timing logic 415 is to continuously sequence through the capture, metrics, and detection cycle, starting each task when the previous tasks that feed it are complete. When detection is complete, another capture is initiated after an optional pre-programmed wait time. Supervisory timing logic 415 also allows baseline metrics to be recalculated on a captured baseline signal stored in memory when any configure metrics (i.e., from configure metrics 430) change.

Configure metrics 430 includes band calculations 431, filter coefficient calculations 432, and order calculations 433. The modules and calculations of configure metrics 430 apply settings to runtime metrics 440 and baseline metrics 450 that determines how signals will be processed to produce metrics according to one or more fault conditions to be monitored, wherein fault conditions may include fault conditions associated with a motor and/or a connected mechanical load of an industrial operation to which the drive supplies power. Modules of configure metrics 430 may provide information to runtime metrics 440 and baseline metries 450 related to how to process signals including determining which filter types to use, filter settings and coefficients, algorithms and algorithms settings, and other information that may affect how metrics are generated for the one or more fault conditions. Band calculations 431 calculates frequency bin vectors that are used to generate multiple band limited frequency responses in frequency response 444 and 454. When a different fault condition is being monitored, the settings within runtime metries 440 and baseline metrics 450 change as controlled by configure metrics 430 based on the fault condition.

Runtime metrics 440 includes filters 441, averages 442, pattern 443, and frequency response 444, each of which may comprise a plurality of components for processing signals to produce metrics including filtering, measurements, calculations, pattern recognition, frequency response analysis, and other means of processing relevant information. Baseline metrics 450 includes filters 451, averages 452, pattern 453, and frequency response 454, each of which may comprise a plurality of components for processing signals to produce metrics including filtering, measurements, calculations, pattern recognition, frequency response analysis, and other means of processing relevant information. In some embodiments, runtime metrics 440 processes recent runtime signal data and baseline metrics 450 processes historical baseline signal data. Each of runtime metrics 440 and baseline metrics 450 may apply a plurality of filters, bandpass filters, algorithms, and other measurements or models to signal data to produce metrics that can be used for fault detection according to the configurations provided by configure metrics 430. Each of runtime metrics 440 and baseline metrics 450 includes a plurality of bus selectors that may be configured according to configure metrics 430. Outputs of runtime metrics 440 and baseline metrics 450 may then provide metrics to detection 460.

Detection 460 includes differences 461, thresholds 462, and metrics out 463. The modules of detection 460 may utilize the metrics provided to detection 460 to identify unhealthy operating conditions, degradation, differences, exceeded thresholds, or the like. In some examples, differences are combined in a mathematical combination (i.e., a configurable weighted sum difference) and then provided to thresholds 462. In other examples, detection 460 may use machine learning techniques to identify fault conditions or when faults are likely to occur before they happen. Detection 460 also includes a plurality of bus selectors that may be configured to process metrics in a certain way by configure metrics 430. Data from detection 460 may then be output to various places including external detection modules at the system or enterprise level.

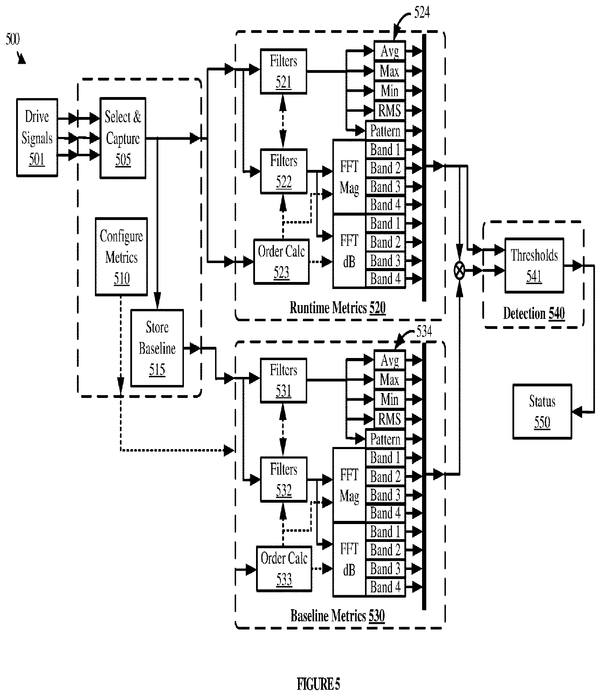

Figure 5 illustrates an additional example of a system architecture for an embedded analytic engine for a motor drive. Analytic engine 500 receives drive signals 501 from a device or system comprising rotating machinery powered by the motor drive and associated sensors. Select and capture 505 selects and captures signals from drive signals 501 and provides the signals to store baseline 515, filters 521, and order calculation block 523. Configure metrics 510 may provide configurations for runtime metrics 520, baseline metrics 530, or both. Store baseline 515 may store baseline signal data so that metrics may be recalculated via baseline metrics 530 when changes are made to parameters and settings in configure metrics 510. This allows the original baseline signal to be used without requiring a new baseline to be captured a period of time after the machine has degraded from healthy conditions. In this manner, settings and operations of analytic engine 500 are configurable even after baseline data has been collected.

Runtime metrics 520 is provided the latest signals captured during runtime including during both healthy and unhealthy conditions. Runtime metrics 520 includes filters 521, filters 522, and order calculation block 523. Filters 521 and filters 522 allow for separate filtering of signals supplied to operations 524. Order calculation block 523 calculates order based on mechanical rotor frequency (speed) or electrical stator frequency. Operations 524 includes a plurality of filters, algorithms, measurements, and similar processing components that may be utilized and configured according to settings associated with a fault condition. Operations 524 may include frequency domain metrics, such as multiple band limited FFT calculations in units of normalized magnitude and in units of decibels. Operations 524 may include time domain metrics to calculate averages, maximums, minimums, RMS, pattern recognition, correlation, variance, and similar time domain measurements. Runtime metrics 520 may then provide the calculated metrics as output. The output may be provided directly to detection 540 and also used to determine a difference between the latest metrics and the baseline metrics, which may then be provided to detection 540. In some examples, the differences are combined in a configurable weighted sum difference.

Similarly, baseline metrics 530 is provided baseline signals captured during healthy conditions. Baseline metrics 530 includes filters 531, filters 532, and order calculation block 533. Filters 531 and filters 532 allow for separate filtering of signals supplied to operations 534. Order calculation block 533 calculates order based on mechanical rotor frequency (speed) or electrical stator frequency. Operations 534 includes a plurality of filters, algorithms, measurements, and similar processing components that may be utilized and configured according to settings associated with a fault condition. Operations 534 may include frequency domain metrics, such as multiple band limited FFT calculations in units of normalized magnitude and in units of decibels. Operations 534 may include time domain metrics to calculate averages, maximums, minimums, RMS, pattern recognition, correlation, variance, and similar time domain measurements. Baseline metrics 530 may then provide the calculated metrics as output. The output may be provided directly to detection 540 and also used to determine a difference between the latest metrics and the baseline metrics, which may then be provided to detection 540. In some examples, the differences are combined in a configurable weighted sum difference.

The outputs are then used to determine a difference between the metrics and provided to thresholds 541 in detection 540. Detection 540 may process output information to determine percent degradation and other measurements relevant to condition monitoring for a given fault condition. In some examples, thresholds 541 compares metrics and differences against predetermined thresholds to identify if any metrics exceed thresholds for healthy conditions. In other examples, detection 540 may implement machine learning techniques to recognize healthy or unhealthy conditions based on the metrics. Detection 540 may then provide the information as output to indicate a status of the device or system with status 550. Detection 540 may further provide the information to additional systems for external condition monitoring, reporting, or the like.

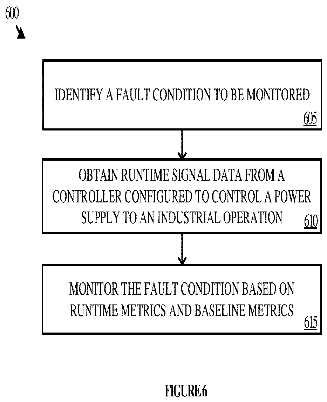

Figure 6 is a flow chart illustrating process 600 for monitoring fault conditions with an embedded analytic engine for VFDs. In step 605, the embedded analytic engine identifies a fault condition to be monitored. A fault condition may be provided by settings configured by a user. In response to identifying a fault condition, the embedded analytic drive may configure components and modules of the drive for processing signal data and monitoring the signal data. In step 610, the analytic engine obtains runtime signal data from a controller configured to control a power supply to an industrial operation. The controller may be an explicit component of the VFD in some examples. The runtime signal data may be collected from one or more sensors associated with the industrial operation and obtained by one or more components of the VFD.

The collected signal data may then be utilized by the embedded analytic engine to monitor the fault condition based on runtime metrics and baseline metrics in step 615. Processing signal data and identifying fault conditions is described in detail with reference to the preceding Figures and is not discussed at length here for purposes of brevity. Baseline metrics are collected during healthy operating conditions and stored to be used during condition monitoring in step 615. The steps included in process 600 are not intended to limit condition monitoring technology as described herein and are provided solely for purposes of explanation.

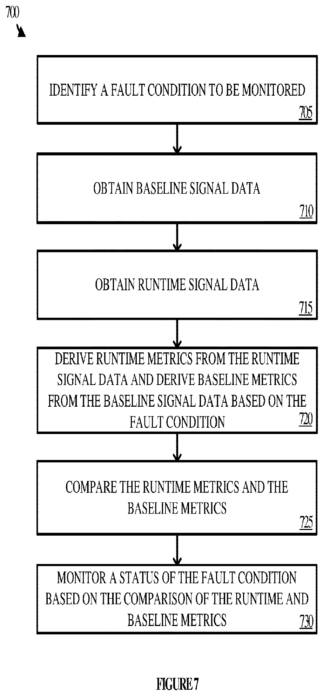

Figure 7 is a flow chart illustrating process 700 for operating an embedded analytic engine in accordance with some embodiments of the present technology. In step 705, the analytic engine identifies a fault condition to be monitored. A fault condition may be provided by settings configured by a user. In response to identifying a fault condition, the embedded analytic drive may configure components and modules of the drive for processing signal data and monitoring the signal data. In step 710, the analytic engine obtains baseline signal data during healthy operating conditions. Baseline signal data may be obtained from one or more locations associated with an industrial operation including the motor drive in which the analytic engine is embedded and/or sensors associated with the industrial operation.

In step 715, the analytic engine obtains runtime signal data. Runtime signal data may be obtained from one or more locations associated with an industrial operation including the motor drive in which the analytic engine is embedded and/or sensors associated with the industrial operation. In step 720, the analytic engine derives runtime metrics from the runtime signal data and derives baseline metrics from the baseline signal data based on the identified fault condition. Deriving runtime metrics and baseline metrics is described in detail in reference to some of the preceding Figures and is therefore not described at length here. After deriving the runtime metrics and baseline metrics, the analytic engine compares the runtime metrics and baseline metrics in step 725. Comparisons may be performed in a variety of manners including but not limited to calculating differences, determining percent degradation, comparing metrics to threshold values, applying machine learning techniques to identify unhealthy conditions, and the like. The analytic engine uses the comparisons to monitor a status of the fault condition based on the comparison of the runtime metrics and the baseline metrics.

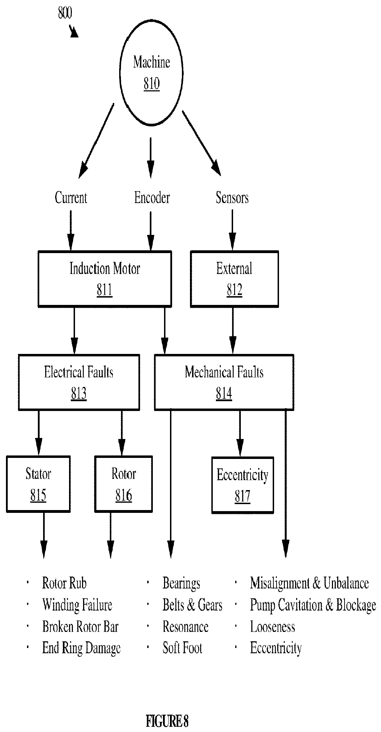

Figure 8 illustrates an example of how faults may be detected for a machine based on the different sources of information. Fault detection environment 800 includes machine 810, which may output information through motor current and voltage, encoders, and sensors. Currents and encoders may provide information related to induction motor 811 of machine 810. Sensors may provide external signals 812. Induction motor 811 may indicate electrical faults 813 which may in turn provide information related to stator 815 and rotor 816 of machine 810. Both induction motor 811 and external signals 812 may provide information related to mechanical faults 814 which can be used to predict failure conditions directly including detecting eccentricity 817.

The information related to stator 815 and rotor 816 may be used to detect failures such as rotor rub, winding failures, broken rotor bars, and end ring damage, as just a few examples. Information related to mechanical faults 814 may include failures related to bearings, belts and gears, resonance, soft foot, misalignment and unbalance, pump cavitation and blockage, looseness, and eccentricity, as just a few examples.

Fault detection environment 800 is provided for purposes of example only. Machine 810 may represent any machine comprising rotating mechanisms that may be powered by a motor drive in accordance with embodiments of the present technology. The types of information and sources of information shown in Figure 8 are not intended to limit the technology but to provide an example of how data signals may provide a means for fault detection for rotating machinery.

When detecting rotor faults, it is important to detect the number of broken rotor bars as early as possible. In existing technology, rotor faults are often detected by analyzing frequency response magnitudes of motor currents (X) in bands around center frequencies (i.e., $f_{rotor} = f_s \pm 2sf$) that are sidebands of the motor electrical frequency $(fs)$ at plus and minus twice the slip frequency $(sf)$. However, analyzing these sideband magnitudes has proven insufficient for accurately detecting rotor faults with an acceptable level of repeatability and reliability.

The method for detecting rotor faults described herein applies a unique combination of measurements on signals that are captured initially (baseline) and most recently (runtime). This creates a stable fault signature that provides repeatable results when a machine learning fault detection approach is applied.

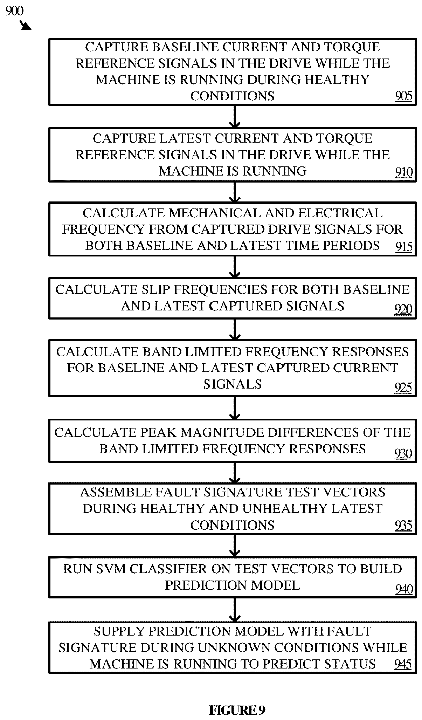

Figure 9 illustrates a series of steps for detecting induction motor rotor faults that uses specific sets of measurements to develop metrics than may then be provided as input to a machine learning module for detecting and/or predicting rotor faults. Step 905 of process 900 includes capturing baseline current and torque reference signals in the drive while the machine is running during healthy conditions. The baseline signal vectors are stored in memory as the phase currents $(i'_a, i'_b, i'_c)$, average of the torque reference $(\tau')$, and the sampling rate *(dt)* for frequency response calculations. In step 910, the latest runtime current and torque reference signals are captured in the drive while the machine is running. The latest signal vectors are then stored, including the latest phase currents $(i_a, i_b, i_c)$, average of the torque reference $(\tau)$, and the sampling rate *(dt)* for frequency response calculations. The band limited frequency response peak magnitude differences between the latest and the baseline versions of the captured motor current signal can be calculated. An activation function used to calculate a difference is sufficient for these purposes. The specific frequency band metrics used to capture fault information are

$$\hat{x}_{f_s-2sf} = 1 - e^{-\log(2)\frac{\max(|X_{f_s-2sf}|-|X'_{f_s-2sf}|)}{\max(|X'_{f_s-2sf}|)}}$$

and

$$\hat{x}_{f_s+2sf} = 1 - e^{-\log(2)\frac{\max(|X_{f_s+2sf}|-|X'_{f_s+2sf}|)}{\max(|X'_{f_s+2sf}|)}}.$$

In step 915, the mechanical and electrical frequencies are calculated from captured drive signals for both the baseline and the runtime time periods. Mechanical frequency may be calculated as $f_r = N_r \frac{p}{120}$, where $N_r$ is the mechanical running speed in units of RPM and $p$ is the number of poles. Electrical frequency, $f_s$, is available in the drive. Alternatively, a frequency spectrum of the captured current signal may be computed over a band of frequencies between $[f_r, 2f_r]$ and then $f_s$ may be set equal to the dominant frequency with the peak magnitude. In step 920, the slip frequencies are calculated for both the baseline and the latest captured signals. Slip frequency, $sf = (f_s - f_r)$, is calculated as the difference between the motor electrical frequency, $f_s$, and the mechanical frequency, $f_r$.

In step 925, the band limited frequency responses are calculated for both the baseline and the latest captured current signals. The band limited frequency responses calculated are $X_{f_s-2sf}$, $X_{f_s+2sf}$, $X'_{f_s-2sf}$, and $X'_{f_s+2sf}$. $X_{f_s-2sf}$ is the set of band limited frequency response magnitudes calculated from a motor current signal that was captured most recently (i.e., latest version). The band of frequency bins extends from $f_s - 3sf$ to $f_s - sf$, with a center frequency of $f_s - 2sf$. $X_{f_s+2sf}$ is a set of band limited frequency response magnitudes calculated from a motor current signal that was captured most recently (i.e., latest version). The band of frequency bins extends from $f_s + sf$ to $f_s + 3sf$, with a center frequency of $f_s + 2sf$. $X'_{f_s-2sf}$ is a set of band limited frequency response magnitudes calculated from a motor current signal that was captured initially during healthy conditions (i.e., baseline version). The band of frequency bins extends from $f_s - 3sf$ to $f_s - sf$, with a ccntcr frequency of $f_s - 2sf$. $X'_{f_s+2sf}$ is a set of band limited frequency response magnitudes calculated from a motor current signal that was captured initially during healthy conditions (i.e., baseline version). The band of frequency bins extends from $f_s + sf$ to $f_s + 3sf$, with a center frequency of $f_s + 2sf$.

In step 930, the peak magnitude differences of the band limited frequency responses are calculated. The peak magnitude differences are calculated as $X_{f_s-2sf}$, $X_{f_s+2sf}$, $X'_{f_s-2sf}$, and $X'_{f_s+2sf}$. In step 935, the fault signature test vectors during healthy and unhealthy latest conditions are calculated and the test vectors are provided to an SVM classifier that builds the prediction model. The fault signature consists of the measurements L$\tau$, $\hat{x}_{f_s-2sf}$, $\hat{x}_{f_s+2sf}$J. In step 940, the SVM classifier is run on the test vectors to build the prediction model. Finally, in step 945, the status of the motor is predicted by supplying the prediction model with the fault signature (i.e., [$\tau$, $\hat{x}_{f_s-2sf}$, $\hat{x}_{f_s+2sf}$]) during unknown conditions while the machine is running to determine if the status is healthy or unhealthy.

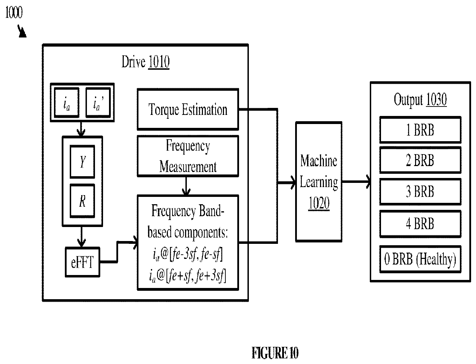

Figure 10 includes block diagram 1000 for rotor fault detection in accordance with certain embodiments of the present technology. The modules shown in block diagram 1000 may be integrated within a drive without the need for external hardware or wiring. Process 900 or a similar process may be implemented in drive 1010. Machine learning is then applied in machine learning module 1020 along with specific information to track load/speed changes. One or more machine learning techniques may be implemented in machine learning module 1020, including but not limited to an SVM classifier. Machine learning module 1020 may use the fault signature information provided by drive 1010 as input to produce output 1030, in which a status is identified. The status may include a number of broken rotor bars (i.e., 1 BRB, 2 BRB, 3 BRB, 4 BRB, or healthy).

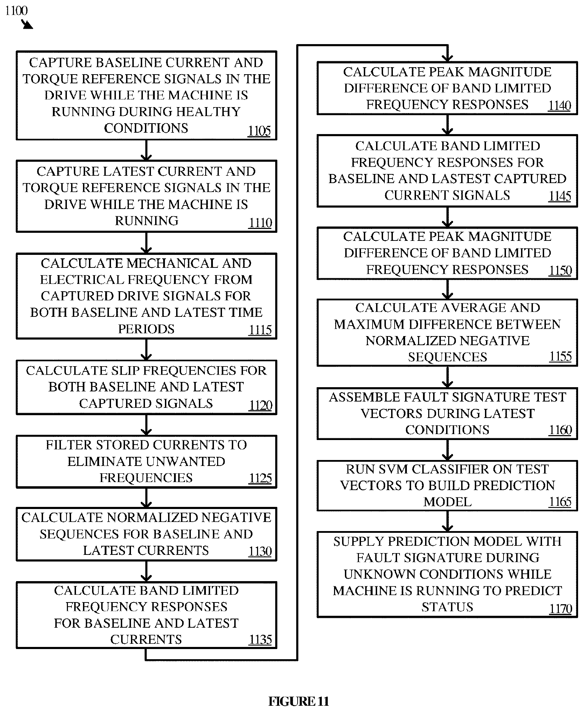

In addition to broken rotor bars, one of the most common faults in stator windings is turn faults. Turn faults are the result of a short circuit caused by insulation breakdown between two or more adjacent winding turns. Turn faults can generate large circulation flow within the shorted turns. The magnitude of the current flow may be on the order of twice the normal blocked rotor current. Without being promptly dctcctcd, shorted turns quickly propagate to phase-to-phase and phase-to-ground faults, which can create irreversible damage to the motor and the machine. As a result, early detection of such faults can avoid hazardous consequences and allow more time for scheduled maintenance. Negative-sequence current and impedance are commonly used to detect short turn faults because the substantial increase in fault information available in the composite signals. It has been shown that the fifth harmonic of negative sequence current is correlated to inter-turn faults while being independent of supply voltage imbalances. It has also been shown that normalizing the negative sequence by dividing it by the positive sequence provides a linear correlation to inter-turn faults. However, analyzing frequency response magnitudes of normalized negative sequence current in the neighborhood of the fifth harmonic alone has proven insufficient in accurately detecting stator faults with any acceptable level of repeatability and reliability due to the presence of noise, non-linear motor effects, and load level. This method of Figure 11 proposes a unique combination of measurements on signals that are captured initially (baseline) and most recently (latest), creating a stable fault signature that provides repeatable results when a machine learning fault detection approach is applied.

Figure 11 illustrates a series of steps for detecting induction motor stator faults that uses specific sets of measurements to develop metrics than may then be provided as input to a machine learning module for detecting and/or predicting stator faults. Step 1105 of process 1100 includes capturing baseline current and torque reference signals in the drive while the machine is running during healthy conditions. The baseline signal vectors are stored in memory as the phase currents $(i'_a, i'_b, i'_c)$, average of the torque reference ($\tau'$), and the sampling rate ($dt$) for frequency response calculations. In step 1110, the latest current and torque reference signals are captured in the drive while the machine is running. The latest signal vectors are then stored, including the latest phase currents ($i_a, i_b, i_c$), average of the torque reference ($\tau$), and the sampling rate ($dt$) for frequency response calculations. The band limited frequency response peak magnitude differences between the latest and the baseline versions of normalized negative sequence and motor current can be calculated. An activation function used to calculate a difference is sufficient for these purposes. The specific frequency band metrics used to capture fault information arc

$$\hat{y}_{5f_s} = 1 - e^{-\log(2)\frac{\max(|Y_{5fs}|-|Y'_{5fs}|)}{\max(|Y'_{5fs}|)}}$$

and

$$\hat{x}_{f_s+f_r} = 1 - e^{-\log(2)\frac{\max(|X_{fs+fr}|-|X'_{fs+fr}|)}{\max(|X'_{fs+fr}|)}}.$$

In step 1115, the mechanical and electrical frequencies arc calculated from captured drive signals for both the baseline and the latest time periods. Mechanical frequency is calculated as $f_r = N_r \frac{p}{120}$, where $N_r$ is the mechanical running speed in units of rotations per minute (RPM) and $p$ is the number of poles. Electrical frequency, $f_s$, is available in the drive. Alternatively, a frequency spectrum of the captured current signal can be computed over a band of frequencies between $[f_r, 2f_r]$ and then $f_s$ may be set equal to the dominant frequency with the peak magnitude. In step 1120, the slip frequencies are calculated for both the baseline and the latest captured signals. Slip frequency, $sf= (f_s-f_r)$, is calculated as the difference between the motor electrical frequency, $f_s$, and the mechanical frequency, $f_r$.

In step 1125, stored currents are filtered to eliminate unwanted frequencies. In the present embodiment, filter, F, is a second order Butterworth low-pass filter with a cut-off frequency of 20*fs ($[i_a, i_b, i_c, i'_a, i'_b, i'_c] = F([i_a, i_b, i_c, i'_a, i'_b, i'_c])$). In step 1130, normalized negative sequences ($i_n, i'_n$) for baseline and latest currents are calculated. To calculate the normalized negative sequences the following equations are used:

$$i_n = \frac{i_a+k^2 i_b+k i_c}{i_a+k i_b+k^2 i_c},$$

$$i'_n = \frac{i'_a+k^2 i'_b+k i'_c}{i'_a+k i'_b+k^2 i'_c},$$

and

$$k = e^{\frac{-j2\pi}{3}}.$$

In step 1135, the band limited frequency responses, $Y_{5f_s}$ and $Y'_{5f_s}$, arc calculated for both the baseline and the latest captured current signals. $Y_{5f_s}$ is a set of band limited frequency response magnitudes calculated from a normalized negative sequence, $i_n$, of motor currents that were captured most recently (i.e., latest version). The band of frequency bins extends from $5f_s$ - $sf$ to $5f_s$ + $sf$ with a center frequency of $5f_s$. $Y'_{5f_s}$ is a set of band limited frequency response magnitudes calculated from a normalized negative sequence, $i_n$, of motor currents that were captured initially during healthy conditions (i.e., baseline version). The band of frequency bins extends from $5f_s - sf$ to $5f_s + sf$ with a center frequency of $5f_s$.

In step 1140, the peak magnitude difference, $\hat{y}_{f_s}$, of the band limited frequency responses is calculated. In step 1145, the band limited frequency responses, $X_{f_s+f_r}$ and $X'_{f_s+f_r}$, for the baseline and latest captured signals are calculated. $X_{f_s+f_r}$ is a set of band limited frequency response magnitudes calculated from a motor current signal that was captured most recently (i.e., latest version). The band of frequency bins extends from $f_s + f_r - sf$ to $f_s + f_r + sf$ with a center frequency of $f_s + f_r$. $X'_{f_s+f_r}$ is a set of band limited frequency response magnitudes calculated from a motor current signal that was captured initially during healthy conditions (i.e., baseline version). The band of frequency bins extends from $f_s + f_r - sf$ to $f_s + f_r + sf$ with a center frequency of $f_s + f_r$.

In step 1150, the peak magnitude difference, $\hat{x}_{f_s+f_r}$ of the band limited frequency responses is calculated. In step 1155, the average and maximum differences between the normalized negative sequences are calculated. The average difference, $M_n^1$, between the normalized negative sequences that were captured most recently (i.e., latest version) and captured initially during healthy conditions (i.e., baseline version) is expressed as

$$M_n^1 = 1 - e^{- \log(2)\frac{|\overline{i_n} - \overline{i'_n}|}{\max(|\overline{i'_n}|)}},$$

where $\overline{i'_n} = \frac{1}{N}\sum_1^N i'_n$, $\overline{i_n} = \frac{1}{N}\sum_1^N i_n$. The maximum difference, $M_n^2$, of the normalized negative sequences that were captured most recently (i.e., latest version) and captured initially during healthy conditions (i.e., baseline version) is expressed as

$$M_n^2 = 1 - e^{- \log(2)\frac{max(|\widehat{i_n} - \widehat{i'_n}|)}{\max(|\widehat{i'_n}|)}},$$

where $\widehat{i_n} = i_n - \overline{i_n}$ and $\widehat{i'_n} = i'_n - \overline{i'_n}$.

In step 1160, the fault signature test vectors, [$\tau$, $\hat{y}_{5f_s}$, $\hat{x}_{f_s+f_r}$, $M_n^1$, $M_n^2$], during healthy and unhealthy latest conditions are calculated and the test vectors are provided to an SVM classifier that builds the prediction model. In step 1165, the SVM classifier is run on the test vectors to build the prediction model. Finally, in step 1170, the status of the motor is predicted by supplying the prediction model with the fault signature ([$\tau$, $\hat{y}_{5f_s}$, $\hat{x}_{f_s+f_r}$, $M_n^1$, $M_n^2$]) during unknown conditions while the machine is running to determine if the status is healthy or unhealthy.

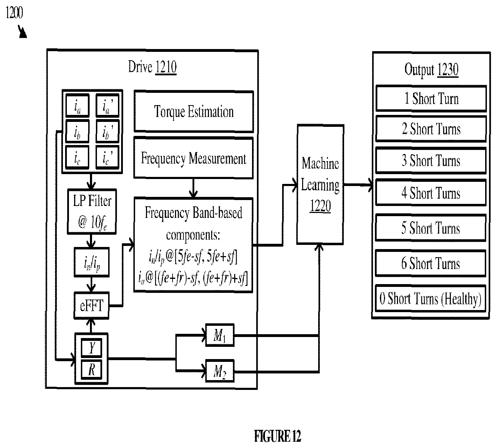

Figure 12 includes block diagram 1200 for stator fault detection in accordance with certain embodiments of the present technology. The modules shown in block diagram 1200 may be integrated within a drive without the need for external hardware or wiring. Process 1100 or a similar process may be implemented in drive 1210. Machine learning is then applied in machine learning module 1220 along with specific information to detect the fault condition while automatically adjusting for load/speed changes. One or more machine learning techniques may be implemented in machine learning module 1220, including but not limited to an SVM classifier. Machine learning module 1220 may use the fault signature information provided by drive 1210 as input to produce output 1230, in which a status is identified. The status may, in some embodiments, include a number of short turns (i.e., 1 short turn, 2 short turns, 3 short turns, 4 short turns, 5 short turns, 6 short turns, or healthy).

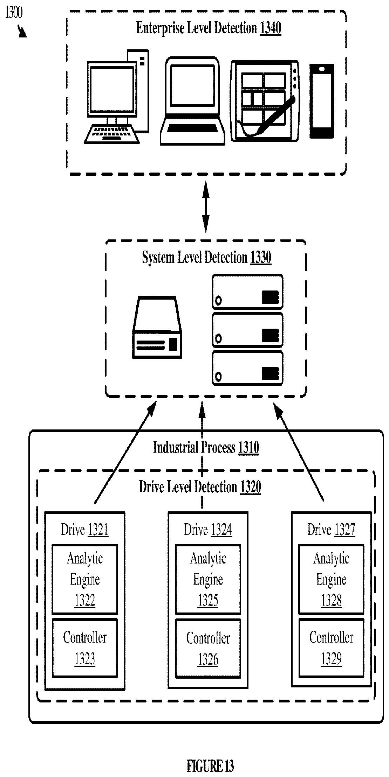

Figure 13 illustrates an example of an industrial enterprise environment comprising multiple levels of fault detection in which embedded drive analytics may be utilized in accordance with some embodiments of the present technology. Industrial enterprise environment 1300 includes industrial process 1310, drive level detection 1320, system level detection 1330, and enterprise level detection 1340. Industrial process 1310 comprises drive level detection 1320. Industrial process 1310 may comprise any number of components, machines, subsystems, controllers, drives, encoders, and similar aspects that may make up an industrial process that can be monitored, at least in part, by an embedded analytic engine in accordance with the present disclosure.

Drive level detection 1320 includes three drives, drive 1321, drive 1324, and drive 1327, in the present example, but may comprise any number of drives associated with industrial process 1310. Drive 1321, drive 1324, and drive 1327 each represent a variable frequency drive in the present embodiment. Drive 1321 comprises analytic engine 1322 and drive controller 1323, drive 1324 comprises analytic engine 1325 and drive controller 1326, and drive 1327 comprises analytic engine 1328 and drive controller 1329. However, VFDs associated with industrial process 1310 may comprise any number or variety of components. Additionally, some drives may not include an analytic engine or a controller. Drive 1321, drive 1324, and drive 1327 may each power a different component of industrial process 1310 in the present example. Thus, each analytic engine in drive level detection 1320 may perform condition monitoring on different data sets associated with different machinery and sensors. Condition monitoring as performed by analytic engine 1322, analytic engine 1325, and analytic engine 1328 may be performed by any or several of the analytic engine system architectures discussed in reference to the preceding Figures including but not limited to Figure 2, Figure 3, Figure 4, and Figure 5.

Drive level detection performed by analytic engine 1322, analytic engine 1325, and analytic engine 1328 includes monitoring fault conditions of an industrial operation to which drive 1321, drive 1324, and drive 1327 supply power. Monitoring fault conditions may include monitoring conditions of a motor, a mechanical load, and variations or combinations thereof. Drive level detection may include power and energy monitoring such as tracking power consumption and identifying energy usage trends. Drive level detection may further include predictive life analysis, component integrity analysis, environmental condition analysis, monitoring failure rates, capturing machine dynamics, detecting abnormal behavior, monitoring the effects of material changes, and load characterization such as performance benchmarking, digital twin analysis, adaptive control, preventative maintenance, and energy diagnostics.

Analytic engine 1322, analytic engine 1325, and analytic engine 1328 may produce signal data, metrics, and results which are communicated to system level detection 1330 in the present example. However, the analytic engines may communicate signal data, metrics, and results that are communicated to additional locations, such as a gateway to enterprise level detection 1340 or other locations. System level detection may comprise any computers, systems, servers, or other machines capable of processing the data from the drives based on instructions and may include one or more machine learning techniques to perform condition monitoring. In some examples, devices of system level detection 1330 may be on-site systems such as PLC automation controllers that are physically connected to the drives, while in other examples, data may be communicated by other means such as Bluetooth, internet, ethernet, and similar network-based communication means. System level detection 1330 may then use metrics from individual drives to perform additional processing to detect fault conditions that arise across a number of drives and devices connected to a PLC automation controller. System level detection 1330, in some examples, employs one or more machine learning techniques to detect failures, monitor conditions, or analyze results from data provided by the drives.

Drive level detection is used in applications where a single stand-alone drive is deployed, or fault conditions arc related to individual drive systems. However, system level detection is used in applications where multiple drives and devices are interconnected to a PLC automation controller, i.e. a machine, or fault conditions are related to the interconnected system or machine.

System level detection serves as an additional detection layer and may include, similar to drive level detection, preventative maintenance for reducing unscheduled downtime, preventing catastrophic failures, and streamlining inventory, and may further include energy diagnostics, system modeling, and performance optimization. The system level detection may help to improve efficiency, reduce operating costs, extend machine life, perform high fidelity simulations and emulations, perform digital twin modeling, verify functionality, predict expected performances, simulate fluctuations, perform mechanical analysis, perform sizing analysis, recommend settings, identify configuration issues, optimize utilization, and identify motion profiles trends.

System level detection 1330 may further communicate with enterprise level detection 1340 that is used to locate and identify problems across a group of systems or machines. Enterprise level detection may be used for remote monitoring with desktop computers, tablets, cell phones, laptops, and other computing devices through which users may monitor conditions via one or more applications associated with the industrial enterprise. Enterprise level detection may include processing trends, machine learning techniques, pattern recognition analysis, expected performance, failure prevention, and root cause analysis, wherein root cause analysis may serve to reduce repair time, reduce common problems, identify the worst problems, and process bottlenecks.

The functions discussed with respect to each of level of detection shown in Figure 13 are described here solely for purposes of example. Additional functionality at each level may exist, and each level may be purposed for functions that differ from the functions described herein. In addition, functionalities described herein may be performed at different levels than described in the present example. The present technology provides the flexibility to customize information for specific applications with the modular topology described herein in which the configurable analytics processor operates as the foundational building block on which application layers may be built on top of to hide complexity and simplify the user experience.

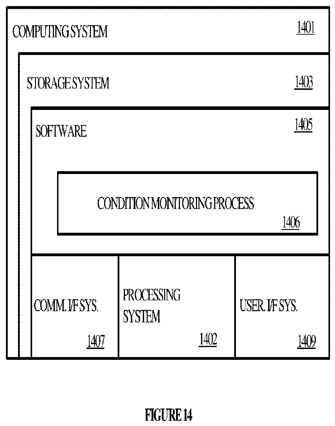

Figure 14 illustrates computing system 1401 to perform condition monitoring according to an implementation of the present technology. Computing system 1401 is representative of any system or collection of systems with which the various operational architectures, processes, scenarios, and sequences disclosed herein for condition monitoring may be employed. Computing system 1401 may be implemented as a single apparatus, system, or device or may be implemented in a distributed manner as multiple apparatuses, systems, or devices. Computing system 1401 includes, but is not limited to, processing system 1402, storage system 1403, software 1405, communication interface system 1407, and user interface system 1409 (optional). Processing system 1402 is operatively coupled with storage system 1403, communication interface system 1407, and user interface system 1409.

Processing system 1402 loads and executes software 1405 from storage system 1403. Software 1405 includes and implements condition monitoring process 1406, which is representative of any of the condition monitoring processes discussed with respect to the preceding Figures. When executed by processing system 1402 to provide condition monitoring functions, software 1405 directs processing system 1402 to operate as described herein for at least the various processes, operational scenarios, and sequences discussed in the foregoing implementations. Computing system 1401 may optionally include additional devices, features, or functionality not discussed for purposes of brevity.

Referring still to Figure 14, processing system 1402 may comprise a microprocessor and other circuitry that retrieves and executes software 1405 from storage system 1403. Processing system 1402 may be implemented within a single processing device but may also be distributed across multiple processing devices or subsystems that cooperate in executing program instructions. Examples of processing system 1402 include general purpose central processing units, graphical processing units, application specific processors, and logic devices, as well as any other type of processing device, combinations, or variations thereof.

Storage system 1403 may comprise any computer readable storage media readable by processing system 1402 and capable of storing software 1405. Storage system 1403 may include volatile and nonvolatile, removable and non-removable media implemented in any method or technology for storage of information, such as computer readable instructions, data structures, program modules, or other data. Examples of storage media include random access memory, read only memory, magnetic disks, optical disks, optical media, flash memory, virtual memory and non-virtual memory, magnetic cassettes, magnetic tape, magnetic disk storage or other magnetic storage dcviccs, or any other suitable storage media. In no case is the computer readable storage media a propagated signal.

In addition to computer readable storage media, in some implementations storage system 1403 may also include computer readable communication media over which at least some of software 1405 may be communicated internally or externally. Storage system 1403 may be implemented as a single storage device but may also be implemented across multiple storage devices or subsystems co-located or distributed relative to each other. Storage system 1403 may comprise additional elements, such as a controller, capable of communicating with processing system 1402 or possibly other systems.

Software 1405 (including condition monitoring process 1406) may be implemented in program instructions and among other functions may, when executed by processing system 1402, direct processing system 1402 to operate as described with respect to the various operational scenarios, sequences, and processes illustrated herein. For example, software 1405 may include program instructions for implementing an embedded analytic engine for motor drives system as described herein.

In particular, the program instructions may include various components or modules that cooperate or otherwise interact to carry out the various processes and operational scenarios described herein. The various components or modules may be embodied in compiled or interpreted instructions, or in some other variation or combination of instructions. The various components or modules may be executed in a synchronous or asynchronous manner, serially or in parallel, in a single threaded environment or multi-threaded, or in accordance with any other suitable execution paradigm, variation, or combination thereof. Software 1405 may include additional processes, programs, or components, such as operating system software, virtualization software, or other application software. Software 1405 may also comprise firmware or some other form of machine-readable processing instructions executable by processing system 1402.

In general, software 1405 may, when loaded into processing system 1402 and executed, transform a suitable apparatus, system, or device (of which computing system 1401 is representative) overall from a general-purpose computing system into a special-purpose computing system customized to provide drive-embedded condition monitoring as described herein. Indeed, encoding software 1405 on storage system 1403 may transform the physical structure of storage system 1403. The specific transformation of the physical structure may depend on various factors in different implementations of this description. Examples of such factors may include, but are not limited to, the technology used to implement the storage media of storage system 1403 and whether the computer-storage media are characterized as primary or secondary storage, as well as other factors.

For example, if the computer readable storage media arc implemented as semiconductor-based memory, software 1405 may transform the physical state of the semiconductor memory when the program instructions are encoded therein, such as by transforming the state of transistors, capacitors, or other discrete circuit elements constituting the semiconductor memory. A similar transformation may occur with respect to magnetic or optical media. Other transformations of physical media arc possible without departing from the scope of the present description, with the foregoing examples provided only to facilitate the present discussion.

Communication interface system 1407 may include communication connections and devices that allow for communication with other computing systems (not shown) over communication networks (not shown). Examples of connections and devices that together allow for inter-system communication may include network interface cards, antennas, power amplifiers, radiofrequency circuitry, transceivers, and other communication circuitry. The connections and devices may communicate over communication media to exchange communications with other computing systems or networks of systems, such as metal, glass, air, or any other suitable communication media. The aforementioned media, connections, and devices are well known and need not be discussed at length here.

Communication between computing system 1401 and other computing systems (not shown), may occur over a communication network or networks and in accordance with various communication protocols, combinations of protocols, or variations thereof. Examples include intranets, internets, the Internet, local area networks, wide area networks, wireless networks, wired networks, virtual networks, software defined networks, data center buses and backplanes, or any other type of network, combination of networks, or variation thereof. The aforementioned communication networks and protocols are well known and need not be discussed at length here.

While some examples provided herein are described in the context of an embedded analytic engine, it should be understood that the condition monitoring systems and methods described herein are not limited to such embodiments and may apply to a variety of other condition monitoring environments and their associated systems. As will be appreciated by one skilled in the art, aspects of the present invention may be embodied as a system, method, computer program product, and other configurable systems. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer readable program code embodied thereon.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number respectively. The word "or," in reference to a list of two or more items, covers all of the following interpretations of the word: any of the items in the list, all of the items in the list, and any combination of the items in the list.

The phrases "in some embodiments," "according to some embodiments," "in the embodiments shown," "in other embodiments," and the like generally mean the particular feature, structure, or characteristic following the phrase is included in at least one implementation of the present technology, and may be included in more than one implementation. In addition, such phrases do not necessarily refer to the same embodiments or different embodiments.

The above Detailed Description of examples of the technology is not intended to be exhaustive or to limit the technology to the precise form disclosed above. While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or subcombinations. Each of these processes or blocks may be implemented in a variety of different ways. Also, while processes or blocks are at times shown as being performed in series, these processes or blocks may instead be performed or implemented in parallel or may be performed at different times. Further any specific numbers noted herein arc only examples: alternative implementations may employ differing values or ranges.

The teachings of the technology provided herein can be applied to other systems, not necessarily the system described above. The elements and acts of the various examples described above can be combined to provide further implementations of the technology. Some alternative implementations of the technology may include not only additional elements to those implementations noted above, but also may include fewer elements.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To rcducc the number of claims, certain aspects of the technology arc presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a mcans-plus-function claim. Any claims intended to be treated under 35 U.S.C. § 112(f) will begin with the words "means for" but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.

**The following is a list of further preferred embodiments of the invention:**

Embodiment 1. An industrial drive comprising:

drive circuitry configured to supply power to a motor in an industrial operation;

a controller coupled with the drive circuitry and configured to control the power supplied to the motor based at least in part on runtime signal data associated with the motor; and

a condition monitoring module configured to:

obtain the runtime signal data from the controller; and

monitor one or more fault conditions of the industrial operation based on metrics comprising runtime metrics derived from the runtime signal data and

baseline metrics derived from baseline signal data.

Embodiment 2. The industrial drive of embodiment 1, wherein the condition monitoring module is further configured to:

identify a fault condition, of the one or more fault conditions, to be monitored;

derive the runtime metrics from the runtime signal data based on settings specific to the fault condition; and

derive the baseline metrics from the baseline signal data based on the settings.

Embodiment 3. The industrial drive of embodiment 2, wherein the settings specific to the fault condition comprise one or more of filter settings, time domain parameters, frequency domain parameters, transform settings, and pattern recognition settings.

Embodiment 4. The industrial drive of embodiment 2, wherein the condition monitoring module is further configured to:

obtain the baseline signal data prior to obtaining the runtime signal data;

store the baseline signal data in the industrial drive; and

synchronize the baseline signal data with the runtime signal data.

Embodiment 5. The industrial drive of embodiment 4, wherein the condition monitoring module is further configured to, when a new motor replaces the motor:

obtain new baseline signal data;

store the new baseline signal data in the industrial drive; and

synchronize the new baseline signal data with the runtime signal data.

Embodiment 6. The industrial drive of embodiment 1, wherein to monitor one or more fault conditions of the industrial operation, the industrial drive is configured to:

generate differential metrics based on the runtime metrics and the baseline metrics; and

supply at least the differential metrics to a detection engine to detect a presence of the one or more fault conditions.

Embodiment 7. The industrial drive of embodiment 6, wherein the detection engine comprises at least one machine learning model configured to classify a condition of the industrial operation based on the differential metrics.

Embodiment 8. One or more computer-readable storage media having program instructions stored thereon to perform condition monitoring in an industrial automation environment, wherein the program instructions, when read and executed by a processing system, direct the processing system to at least:

in a motor drive configured to supply power to a motor in an industrial operation, obtain runtime signal data from one or more sensors associated with the industrial operation;

in the motor drive, derive runtime metrics from the runtime signal data based on settings specific to a fault condition of the industrial operation; and

in the motor drive, monitor the fault condition of the industrial operation based on metrics comprising the runtime metrics derived from the runtime signal data and

baseline metrics derived from baseline signal data.

Embodiment 9. The one or more computer-readable storage media of embodiment 8, wherein the program instructions, when read and executed by the processing system, further direct the processing system to:

in the motor drive, identify the fault condition to be monitored; and

in the motor drive, derive the baseline metrics from the baseline signal data based on the settings.

Embodiment 10. The one or more computer-readable storage media of embodiment 9, wherein the settings specific to the fault condition comprise one or more of filter settings, time domain parameters, frequency domain parameters, transform settings, and pattern recognition settings.

Embodiment 11. The one or more computer-readable storage media of embodiment 9, wherein the program instructions, when read and executed by the processing system, further direct the processing system to:

in the motor drive, obtain the baseline signal data prior to obtaining the runtime signal data;

in the motor drive, store the baseline signal data in a drive associated with the industrial operation; and

in the motor drive, synchronize the baseline signal data with the runtime signal data.

Embodiment 12. The one or more computer-readable storage media of embodiment 11, wherein the program instructions, when read and executed by the processing system, further direct the processing system to, when a new motor replaces the motor:

in the motor drive, obtain new baseline signal data;

in the motor drive, store the new baseline signal data in the drive associated with the industrial operation; and

in the motor drive, synchronize the new baseline signal data with the runtime signal data.

Embodiment 13. The one or more computer-readable storage media of embodiment 8, wherein the program instructions, when read and executed by the processing system, further direct the processing system to:

in the motor drive, generate differential metrics based on the runtime metrics and the baseline metrics; and
in the motor drive, supply at least the differential metrics to a detection engine to detect a presence of the fault condition.

Embodiment 14. The one or more computer-readable storage media of embodiment 13, wherein to detect the presence of the fault condition, the program instructions, when read and executed by the processing system, further direct the processing system to classify a condition of the industrial operation based on the differential metrics using a machine learning model.

Embodiment 15. A method of condition monitoring in an industrial automation environment, the method comprising:

obtaining runtime signal data in a drive configured to control power supplied to a motor in an industrial operation based at least in part on the runtime signal data associated with the industrial operation;

deriving runtime metrics from the runtime signal data based on settings specific to a fault condition of the industrial operation; and

monitoring the fault condition of the industrial operation based on metrics comprising the runtime metrics derived from the runtime signal data and baseline metrics derived from baseline signal data.

Embodiment 16. The method of embodiment 15, further comprising:

identifying the fault condition to be monitored; and

deriving the baseline metrics from the baseline signal data based on the settings.

Embodiment 17. The method of embodiment 16, wherein the settings specific to the fault condition comprise one or more of filter settings, time domain parameters, frequency domain parameters, transform settings, pattern recognition settings, and frequency response settings.

Embodiment 18. The method of embodiment 16, further comprising:

obtaining the baseline signal data prior to obtaining the runtime signal data;

storing the baseline signal data in a drive associated with the industrial operation; and

synchronizing the baseline signal data with the runtime signal data.

Embodiment 19. The method of embodiment 18, further comprising, when a new motor replaces the motor:

obtaining the baseline signal data prior to obtaining the runtime signal data;

storing the baseline signal data in the drive associated with the industrial operation; and

synchronizing the baseline signal data with the runtime signal data.

Embodiment 20. The method of embodiment 15, further comprising:

generating differential metrics based on the runtime metrics and the baseline metrics; and

supplying at least the differential metrics to a detection engine to detect a presence of the fault condition.

Embodiment 21. A method of monitoring a condition of an induction motor in an industrial automation environment, the method comprising:

obtaining runtime signal data in a drive configured to control power supplied to the induction motor in an industrial operation based at least in part on the runtime signal data associated with the industrial operation;

deriving runtime metrics from the runtime signal data based on an induction motor fault condition;

providing the runtime metrics as input to a machine learning model constructed to identify a status of the induction motor based on the runtime metrics and output the status; and

monitoring the induction motor fault condition based on the status of the induction motor output by the machine learning model.

Embodiment 22. The method of embodiment 21, wherein:

the induction motor fault condition is a rotor fault; and

deriving the runtime metrics from the runtime signal data comprises deriving runtime metrics specific to identifying rotor faults.

Embodiment 23. The method of embodiment 22, wherein the machine learning model is constructed to identify a number of broken rotor bars based on the runtime metrics.

Embodiment 24. The method of embodiment 21, wherein:

the induction motor fault condition is a stator fault; and

deriving the runtime metrics from the runtime signal data comprises deriving runtime metrics specific to identifying stator faults.

Embodiment 25. The method of embodiment 24, wherein the machine learning model is constructed to identify a number of stator winding short turns based on the runtime metrics.

Embodiment 26. The method of embodiment 21, further comprising:

obtaining baseline signal data prior to obtaining the runtime signal data, wherein the baseline signal data represents a healthy condition of the induction motor;

storing the baseline signal data in the drive; and

deriving baseline metrics from the baseline signal data.

Embodiment 27. The method of embodiment 21, wherein deriving the runtime metrics comprises:

determining a frequency response of the runtime signal data; and

generating a fault signature comprising a torque reference signal, the frequency response, and machine speed.

Embodiment 28. An industrial drive comprising:

drive circuitry configured to supply power to an induction motor in an industrial operation;

a controller coupled with the drive circuitry and configured to control the power supplied to the induction motor based at least in part on runtime signal data associated with the induction motor; and

a condition monitoring module configured to:

obtain the runtime signal data from the controller;

derive runtime metrics from the runtime signal data based on an induction motor fault condition;

provide the runtime metrics as input to a machine learning model constructed to identify a status of the induction motor based on the runtime metrics and output the status; and

monitor the induction motor fault condition based on the status of the induction motor output by the machine learning model.

Embodiment 29. The industrial drive of embodiment 28, wherein:

the induction motor fault condition is a rotor fault; and

deriving the runtime metrics from the runtime signal data comprises deriving runtime metrics specific to identifying rotor faults.

Embodiment 30. The industrial drive of embodiment 29, wherein the machine learning model is constructed to identify a number of broken rotor bars based on the runtime metrics.

Embodiment 31. The industrial drive of embodiment 28, wherein:

the induction motor fault condition is a stator fault; and

deriving the runtime metrics from the runtime signal data comprises deriving runtime metrics specific to identifying stator faults.

Embodiment 32. The industrial drive of embodiment 31, wherein the machine learning model is constructed to identify a number of stator winding short turns based on the runtime metrics.

Embodiment 33. The industrial drive of embodiment 28, wherein the condition monitoring module is further configured to:

obtain baseline signal data prior to obtaining the runtime signal data, wherein the baseline signal data represents a healthy condition of the induction motor;

store the baseline signal data in the industrial drive; and

derive baseline metrics from the baseline signal data.

Embodiment 34. The industrial drive of embodiment 28, wherein the condition monitoring module, to derive the runtime metrics, is configured to:

determine a frequency response of the runtime signal data; and
generate a fault signature comprising a torque reference signal, the frequency response, and machine speed.

Embodiment 35. One or more computer-readable storage media having program instructions stored thereon to perform condition monitoring in an industrial automation environment, wherein the program instructions, when read and executed by a processing system, direct the processing system to at least:

in a motor drive configured to supply power to an induction motor in an industrial operation based at least in part on runtime signal data, obtain the runtime signal data;

in the motor drive, derive runtime metrics from the runtime signal data based on an induction motor fault condition;

in the motor drive, provide the runtime metrics as input to a machine learning model constructed to identify a status of the induction motor based on the runtime metrics and output the status; and

in the motor drive, monitor the induction motor fault condition based on the status of the induction motor output by the machine learning model.

Embodiment 36. The one or more computer-readable storage media of embodiment 35, wherein:

the induction motor fault condition is a rotor fault; and

to derive the runtime metrics from the runtime signal data, the program instructions, when read and executed by the processing system, direct the processing system to derive runtime metrics specific to identifying rotor faults.

Embodiment 37. The one or more computer-readable storage media of embodiment 36, wherein the machine learning model is constructed to identify a number of broken rotor bars based on the runtime metrics.

Embodiment 38. The one or more computer-readable storage media of embodiment 35, wherein:

the induction motor fault condition is a stator fault; and
to derive the runtime metrics from the runtime signal data, the program instructions, when read and executed by the processing system, direct the processing system to derive runtime metrics specific to identifying stator faults.

Embodiment 39. The one or more computer-readable storage media of embodiment 38, wherein the machine learning model is constructed to identify a number of stator winding short turns based on the runtime metrics.

Embodiment 40. The one or more computer-readable storage media of embodiment 35, wherein to derive the runtime metrics, the program instructions, when read and executed by the processing system, direct the processing system to:

determine a frequency response of the runtime signal data; and

generate a fault signature comprising a torque reference signal, the frequency response, and machine speed.

## Claims

1. A method of condition monitoring in an industrial automation environment, the method comprising:

obtaining runtime signal data in a drive configured to control power supplied to a motor in an industrial operation based at least in part on the runtime signal data associated with the industrial operation;

deriving runtime metrics from the runtime signal data based on settings specific to a fault condition of the industrial operation; and
monitoring the fault condition of the industrial operation based on metrics comprising the runtime metrics derived from the runtime signal data and baseline metrics derived from baseline signal data.

2. The method of claim 1, further comprising:

identifying the fault condition to be monitored; and
deriving the baseline metrics from the baseline signal data based on the settings.

3. The method of claim 2, wherein the settings specific to the fault condition comprise one or more of filter settings, time domain parameters, frequency domain parameters, transform settings, pattern recognition settings, and frequency response settings.

4. The method of claim 2, further comprising:

obtaining the baseline signal data prior to obtaining the runtime signal data;
storing the baseline signal data in a drive associated with the industrial operation; and
synchronizing the baseline signal data with the runtime signal data.

5. The method of claim 4, further comprising, when a new motor replaces the motor:

obtaining the baseline signal data prior to obtaining the runtime signal data;
storing the baseline signal data in the drive associated with the industrial operation; and
synchronizing the baseline signal data with the runtime signal data.

6. The method of one of claims 1 to 5, further comprising:

generating differential metrics based on the runtime metrics and the baseline metrics; and
supplying at least the differential metrics to a detection engine to detect a presence of the fault condition.

7. An industrial drive comprising:

drive circuitry configured to supply power to a motor in an industrial operation;
a controller coupled with the drive circuitry and configured to control the power supplied to the motor based at least in part on runtime signal data associated with the motor; and

a condition monitoring module configured to:

> obtain the runtime signal data from the controller; and
> monitor one or more fault conditions of the industrial operation based on metrics comprising runtime metrics derived from the runtime signal data and baseline metrics derived from baseline signal data.

8. The industrial drive of claim 7, wherein the condition monitoring module is further configured to:

> identify a fault condition, of the one or more fault conditions, to be monitored;
> derive the runtime metrics from the runtime signal data based on settings specific to the fault condition; and
> derive the baseline metrics from the baseline signal data based on the settings; and/or
> wherein the condition monitoring module is further configured to:
>
> > obtain the baseline signal data prior to obtaining the runtime signal data;
> > store the baseline signal data in the industrial drive; and
> > synchronize the baseline signal data with the runtime signal data.

9. The industrial drive of claim 7 or 8, wherein to monitor one or more fault conditions of the industrial operation, the industrial drive is configured to:

> generate differential metrics based on the runtime metrics and the baseline metrics; and
> supply at least the differential metrics to a detection engine to detect a presence of the one or more fault conditions.

10. The industrial drive of claim 9, wherein the detection engine comprises at least one machine learning model configured to classify a condition of the industrial operation based on the differential metrics.

11. A method of monitoring a condition of an induction motor in an industrial automation environment, the method comprising:

> obtaining runtime signal data in a drive configured to control power supplied to the induction motor in an industrial operation based at least in part on the runtime signal data associated with the industrial operation;
> deriving runtime metrics from the runtime signal data based on an induction motor fault condition;
> providing the runtime metrics as input to a machine learning model constructed to identify a status of the induction motor based on the runtime metrics and output the status; and
monitoring the induction motor fault condition based on the status of the induction motor output by the machine learning model.

12. The method of claim 11, wherein:

> the induction motor fault condition is a rotor fault; and
> deriving the runtime metrics from the runtime signal data comprises deriving runtime metrics specific to identifying rotor faults,
> wherein the machine learning model is constructed to identify a number of broken rotor bars based on the runtime metrics; or
> wherein:
>
> > the induction motor fault condition is a stator fault; and
> > deriving the runtime metrics from the runtime signal data comprises deriving runtime metrics specific to identifying stator faults,
> > wherein the machine learning model is constructed to identify a number of stator winding short turns based on the runtime metrics.

13. The method of claim 11 or 12, further comprising:

> obtaining baseline signal data prior to obtaining the runtime signal data, wherein the baseline signal data represents a healthy condition of the induction motor;
> storing the baseline signal data in the drive; and
> deriving baseline metrics from the baseline signal data; or
> wherein deriving the runtime metrics comprises:
>
> > determining a frequency response of the runtime signal data; and
> > generating a fault signature comprising a torque reference signal, the frequency response, and machine speed.

14. An industrial drive comprising:

> drive circuitry configured to supply power to an induction motor in an industrial operation;
> a controller coupled with the drive circuitry and configured to control the power supplied to the induction motor based at least in part on runtime signal data associated with the induction motor; and
> a condition monitoring module configured to:
>
> > obtain the runtime signal data from the controller;

derive runtime metrics from the runtime signal data based on an induction motor fault condition;

provide the runtime metrics as input to a machine learning model constructed to identify a status of the induction motor based on the runtime metrics and output the status; and

monitor the induction motor fault condition based on the status of the induction motor output by the machine learning model.

15. The industrial drive of claim 14, wherein:

the induction motor fault condition is a rotor fault; and

deriving the runtime metrics from the runtime signal data comprises deriving runtime metrics specific to identifying rotor faults,

wherein the machine learning model is constructed to identify a number of broken rotor bars based on the runtime metrics; or

wherein:

the induction motor fault condition is a stator fault; and

deriving the runtime metrics from the runtime signal data comprises deriving runtime metrics specific to identifying stator faults,

wherein the machine learning model is constructed to identify a number of stator winding short turns based on the runtime metrics.

100

Industrial Operation
120

Sensors
121

Controllers
122

Encoders
123

Motors
124

◄—Power—

—Signal Data►

Variable Frequency Drive
110

Analytic Engine
111

Fault Detection Process
112

Controller
113

Circuitry
114

External Systems
130

System Analytics
131

Enterprise Analytics
132

Cloud Analytics
133

Controllers
134

FIGURE 1

200

Cloud Detection 260

Gateway 250

Machine 220

Drive Controller 211

Drive Signals

Sensors 230

Select & Capture 212

Metrics 213

Drive Level Detection 214

System Detection 240

Drive 210

FIGURE 2

300

**RT Filters** **321**

**RT Metrics** **322**

**RT Threshold** **323**

Real Time Section **320**

**Signal Select** **311**

**Capture** **312**

**Metric Config** **313**

**Order Calc** **314**

**Timing Logic** **315**

Capture & Configure **310**

**Filters** **331**

**Time Metrics** **332**

**Pattern Recognition** **333**

**Frequency Response** **334**

Runtime Metrics **330**

**Thresholds** **351**

**Percent Degradation** **352**

Detection **350**

**Filters** **341**

**Time Metrics** **342**

**Pattern Recognition** **343**

**Frequency Response** **344**

Baseline Metrics **340**

FIGURE 3

FIGURE 4

FIGURE 5

600

IDENTIFY A FAULT CONDITION TO BE MONITORED
605

OBTAIN RUNTIME SIGNAL DATA FROM A
CONTROLLER CONFIGURED TO CONTROL A POWER
SUPPLY TO AN INDUSTRIAL OPERATION    610

MONITOR THE FAULT CONDITION BASED ON
RUNTIME METRICS AND BASELINE METRICS
615

FIGURE 6

700

```
┌─────────────────────────────────────────┐
│  IDENTIFY A FAULT CONDITION TO BE MONITORED │
│                                      705  │
└─────────────────────────────────────────┘
                    │
                    ▼
┌─────────────────────────────────────────┐
│        OBTAIN BASELINE SIGNAL DATA        │
│                                      710  │
└─────────────────────────────────────────┘
                    │
                    ▼
┌─────────────────────────────────────────┐
│        OBTAIN RUNTIME SIGNAL DATA         │
│                                      715  │
└─────────────────────────────────────────┘
                    │
                    ▼
┌─────────────────────────────────────────┐
│  DERIVE RUNTIME METRICS FROM THE RUNTIME  │
│  SIGNAL DATA AND DERIVE BASELINE METRICS  │
│  FROM THE BASELINE SIGNAL DATA BASED ON THE │
│  FAULT CONDITION                     720   │
└─────────────────────────────────────────┘
                    │
                    ▼
┌─────────────────────────────────────────┐
│     COMPARE THE RUNTIME METRICS AND THE   │
│            BASELINE METRICS               │
│                                      725   │
└─────────────────────────────────────────┘
                    │
                    ▼
┌─────────────────────────────────────────┐
│  MONITOR A STATUS OF THE FAULT CONDITION  │
│  BASED ON THE COMPARISON OF THE RUNTIME AND │
│         BASELINE METRICS             730    │
└─────────────────────────────────────────┘
```

FIGURE 7

800

Machine
810

Current     Encoder     Sensors

| Induction Motor 811 | External 812 |
| --- | --- |

| Electrical Faults 813 | Mechanical Faults 814 |
| --- | --- |

| Stator 815 | Rotor 816 | | Eccentricity 817 |
| --- | --- | --- | --- |

- Rotor Rub
- Winding Failure
- Broken Rotor Bar
- End Ring Damage

- Bearings
- Belts & Gears
- Resonance
- Soft Foot

- Misalignment & Unbalance
- Pump Cavitation & Blockage
- Looseness
- Eccentricity

FIGURE 8

900

CAPTURE BASELINE CURRENT AND TORQUE REFERENCE SIGNALS IN THE DRIVE WHILE THE MACHINE IS RUNNING DURING HEALTHY CONDITIONS 905

CAPTURE LATEST CURRENT AND TORQUE REFERENCE SIGNALS IN THE DRIVE WHILE THE MACHINE IS RUNNING 910

CALCULATE MECHANICAL AND ELECTRICAL FREQUENCY FROM CAPTURED DRIVE SIGNALS FOR BOTH BASELINE AND LATEST TIME PERIODS 915

CALCULATE SLIP FREQUENCIES FOR BOTH BASELINE AND LATEST CAPTURED SIGNALS 920

CALCULATE BAND LIMITED FREQUENCY RESPONSES FOR BASELINE AND LATEST CAPTURED CURRENT SIGNALS 925

CALCULATE PEAK MAGNITUDE DIFFERENCES OF THE BAND LIMITED FREQUENCY RESPONSES 930

ASSEMBLE FAULT SIGNATURE TEST VECTORS DURING HEALTHY AND UNHEALTHY LATEST CONDITIONS 935

RUN SVM CLASSIFIER ON TEST VECTORS TO BUILD PREDICTION MODEL 940

SUPPLY PREDICTION MODEL WITH FAULT SIGNATURE DURING UNKNOWN CONDITIONS WHILE MACHINE IS RUNNING TO PREDICT STATUS 945

FIGURE 9

1000

Drive 1010

| $i_a$ | $i_a$' |

Torque Estimation

$Y$

$R$

Frequency Measurement

eFFT

Frequency Band-based components:
$i_a@[fe\text{-}3sf, fe\text{-}sf]$
$i_a@[fe\text{+}sf, fe\text{+}3sf]$

Machine Learning 1020

Output 1030

1 BRB

2 BRB

3 BRB

4 BRB

0 BRB (Healthy)

FIGURE 10

EP 3 904 988 A1

1100

CAPTURE BASELINE CURRENT AND
TORQUE REFERENCE SIGNALS IN THE
DRIVE WHILE THE MACHINE IS
RUNNING DURING HEALTHY
CONDITIONS                    1105

CAPTURE LATEST CURRENT AND
TORQUE REFERENCE SIGNALS IN THE
DRIVE WHILE THE MACHINE IS
RUNNING                       1110

CALCULATE MECHANICAL AND
ELECTRICAL FREQUENCY FROM
CAPTURED DRIVE SIGNALS FOR
BOTH BASELINE AND LATEST TIME
PERIODS                       1115

CALCULATE SLIP FREQUENCIES FOR
BOTH BASELINE AND LATEST
CAPTURED SIGNALS              1120

FILTER STORED CURRENTS TO
ELIMINATE UNWANTED
FREQUENCIES                   1125

CALCULATE NORMALIZED NEGATIVE
SEQUENCES FOR BASELINE AND
LATEST CURRENTS               1130

CALCULATE BAND LIMITED
FREQUENCY RESPONSES
FOR BASELINE AND LATEST
CURRENTS                      1135

CALCULATE PEAK MAGNITUDE
DIFFERENCE OF BAND LIMITED
FREQUENCY RESPONSES     1140

CALCULATE BAND LIMITED
FREQUENCY RESPONSES FOR
BASELINE AND LASTEST CAPTURED
CURRENT SIGNALS          1145

CALCULATE PEAK MAGNITUDE
DIFFERENCE OF BAND LIMITED
FREQUENCY RESPONSES     1150

CALCULATE AVERAGE AND
MAXIMUM DIFFERENCE BETWEEN
NORMALIZED NEGATIVE
SEQUENCES                1155

ASSEMBLE FAULT SIGNATURE TEST
VECTORS DURING LATEST
CONDITIONS               1160

RUN SVM CLASSIFIER ON TEST
VECTORS TO BUILD PREDICTION
MODEL                    1165

SUPPLY PREDICTION MODEL WITH
FAULT SIGNATURE DURING
UNKNOWN CONDITIONS WHILE
MACHINE IS RUNNING TO PREDICT
STATUS                   1170

FIGURE 11

35

1200

Drive 1210

| $i_a$ | $i_a{}'$ |
| $i_b$ | $i_b{}'$ |
| $i_c$ | $i_c{}'$ |

Torque Estimation

Frequency Measurement

LP Filter @ $10f_e$

$i_n/i_p$

eFFT

Frequency Band-based components:

$i_n/i_p$ @ [$5f_e$-$sf$, $5f_e$+$sf$]

$i_a$ @ [($f_e$+$f_r$)-$sf$, ($f_e$+$f_r$)+$sf$]

Y

R

$M_1$

$M_2$

Machine Learning 1220

Output 1230

| 1 Short Turn |
| 2 Short Turns |
| 3 Short Turns |
| 4 Short Turns |
| 5 Short Turns |
| 6 Short Turns |
| 0 Short Turns (Healthy) |

FIGURE 12

FIGURE 13

COMPUTING SYSTEM      <u>1401</u>

STORAGE SYSTEM      <u>1403</u>

SOFTWARE      <u>1405</u>

CONDITION MONITORING PROCESS

<u>1406</u>

COMM. I/F SYS.

<u>1407</u>

PROCESSING SYSTEM

<u>1402</u>

USER. I/F SYS.

<u>1409</u>

FIGURE 14

Europäisches
Patentamt

European
Patent Office

Office européen
des brevets

# EUROPEAN SEARCH REPORT

Application Number

EP 21 17 0408

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/241888 A1 (LU BIN [US] ET AL) 6 October 2011 (2011-10-06) | 1-9 | INV. G05B23/02 |
| Y | * paragraph [0007] - paragraph [0009] * <br> * paragraph [0021] - paragraph [0027] * <br> * paragraph [0033] - paragraph [0036] * <br> * paragraph [0039] - paragraph [0040] * <br> * paragraph [0042] - paragraph [0043] * <br> * figures 1,6 * | 13 | |
| X | EP 1 491 977 A2 (EATON CORP) 29 December 2004 (2004-12-29) * paragraph [0011] - paragraph [0014] * <br> * paragraph [0018] - paragraph [0021] * <br> * paragraph [0023] - paragraph [0024] * <br> * figures 1,2 * | 1-6 | |
| X | US 2012/001580 A1 (ZHANG PINJIA [US] ET AL) 5 January 2012 (2012-01-05) | 1,7 | |
| Y | * paragraph [0007] - paragraph [0008] * <br> * paragraph [0029] - paragraph [0030] * <br> * paragraph [0036] * <br> * paragraph [0042] - paragraph [0044] * <br> * figures 1,2,7 * | 10-15 | TECHNICAL FIELDS SEARCHED (IPC) |
| Y | US 2018/062553 A1 (VAN HOANG TRAN [US] ET AL) 1 March 2018 (2018-03-01) * paragraph [0015] * <br> * paragraph [0020] - paragraph [0023] * <br> * paragraph [0028] - paragraph [0031] * <br> * paragraph [0061] - paragraph [0062] * <br> * figures 1-3 * | 11-15 | F04D G05B G01R H02P |

-/--

The present search report has been drawn up for all claims

| Place of search | Date of completion of the search | Examiner |
|---|---|---|
| Munich | 21 September 2021 | Hristov, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

| | Europäisches Patentamt |  | | |
|---|---|---|---|---|
| | European Patent Office | **EUROPEAN SEARCH REPORT** | | **Application Number** |
| | Office européen des brevets | | | EP 21 17 0408 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ALI MOHAMMAD ZAWAD ET AL: "Machine Learning Based Fault Diagnosis for Single-and Multi-Faults for Induction Motors Fed by Variable Frequency Drives", 2019 IEEE INDUSTRY APPLICATIONS SOCIETY ANNUAL MEETING, IEEE, 29 September 2019 (2019-09-29), pages 1-14, XP033665137, DOI: 10.1109/IAS.2019.8912395 [retrieved on 2019-11-25] * chapter I. INTRODUCTION * * chapter II. THE PROPOSED FAULT DIAGNOSIS APPROACH * * page 3, left column, second paragraph * * figures 1, 2, 4 * ----- | 10-15 | |
| Y | GANGSAR PURUSHOTTAM ET AL: "Signal based condition monitoring techniques for fault detection and diagnosis of induction motors: A state-of-the-art review", MECHANICAL SYSTEMS AND SIGNAL PROCESSING, ELSEVIER, AMSTERDAM, NL, vol. 144, 24 April 2020 (2020-04-24), XP086202831, ISSN: 0888-3270, DOI: 10.1016/J.YMSSP.2020.106908 [retrieved on 2020-04-24] * chapter 2.2.1 to chapter 2.2.2 * * chapter 3.1 to chapter 3.2.3 * * chapter 4 * * figures 2, 20 * ----- -/-- | 10-15 | TECHNICAL FIELDS SEARCHED (IPC) |

The present search report has been drawn up for all claims

| Place of search | Date of completion of the search | Examiner |
|---|---|---|
| Munich | 21 September 2021 | Hristov, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.............................................................
& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 21 17 0408

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DAI XUEWU ET AL: "From Model, Signal to Knowledge: A Data-Driven Perspective of Fault Detection and Diagnosis", IEEE TRANSACTIONS ON INDUSTRIAL INFORMATICS, IEEE SERVICE CENTER, NEW YORK, NY, US, vol. 9, no. 4, 1 November 2013 (2013-11-01), pages 2226-2238, XP011530597, ISSN: 1551-3203, DOI: 10.1109/TII.2013.2243743 [retrieved on 2013-10-14] * page 2228, left column, last paragraph to right column, first paragraph * * Chapter IV. SIGNAL-BASED DATA-DRIVEN FDD * * Chapter V. KNOWLEDGE-BASED HISTORIC DATA-DRIVEN FDD * ----- | 1-15 | |

TECHNICAL FIELDS
SEARCHED     (IPC)

The present search report has been drawn up for all claims

| Place of search | Date of completion of the search | Examiner |
|---|---|---|
| Munich | 21 September 2021 | Hristov, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 17 0408

This annex lists the patent family members relating to the patent documents cited in  the above-mentioned European search report.
The members are as contained in the European Patent Office EDP file on
The European Patent Office is in no way liable for these particulars which are merely given for the purpose of information.

21-09-2021

| Patent document cited in search report | | Publication date | Patent family member(s) | | Publication date |
|---|---|---|---|---|---|
| US 2011241888 | A1 | 06-10-2011 | AU | 2011236558 A1 | 25-10-2012 |
| | | | BR | 112012025201 A2 | 21-06-2016 |
| | | | CA | 2795504 A1 | 13-10-2011 |
| | | | CN | 102939463 A | 20-02-2013 |
| | | | EP | 2556257 A1 | 13-02-2013 |
| | | | TW | 201137239 A | 01-11-2011 |
| | | | US | 2011241888 A1 | 06-10-2011 |
| | | | WO | 2011124963 A1 | 13-10-2011 |
| | | | ZA | 201207270 B | 28-05-2014 |
| EP 1491977 | A2 | 29-12-2004 | EP | 1489474 A2 | 22-12-2004 |
| | | | EP | 1489475 A2 | 22-12-2004 |
| | | | EP | 1491977 A2 | 29-12-2004 |
| | | | US | 2005007096 A1 | 13-01-2005 |
| | | | US | 2005021301 A1 | 27-01-2005 |
| | | | US | 2005021302 A1 | 27-01-2005 |
| | | | US | 2006196265 A1 | 07-09-2006 |
| | | | US | 2007005291 A1 | 04-01-2007 |
| US 2012001580 | A1 | 05-01-2012 | NONE | | |
| US 2018062553 | A1 | 01-03-2018 | US | 2018062553 A1 | 01-03-2018 |
| | | | WO | 2018044483 A1 | 08-03-2018 |

EPO FORM P0459

For more details about this annex : see Official Journal of the European Patent Office, No. 12/82

**EP 3 904 988 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 86473920